# EUROPEAN PATENT APPLICATION

(11) **EP 4 672 335 A1**
(43) Date of publication of application: **31.12.2025**
(21) Application number: 25182672.3
(22) Date of filing: 13.06.2025
(51) Int. Cl.: H01L 23/532, H01L 21/768, H01L 21/285, C23C 16/04, C23C 16/18, C23C 16/455

(54) **INTERCONNECT STRUCTURE AND INTEGRATED CIRCUIT DEVICE**

(30) Priority: 19.06.2024 KR 20240079932; 28.04.2025 KR 20250055238
(71) Applicant: Samsung Electronics Co., Ltd., Suwon-si, Gyeonggi-do 16677 (KR)
(72) Inventor: Leem, Youngchul, 16678 Suwon-si, Gyeonggi-do (KR); Lee, Young Min, 16678 Suwon-si, Gyeonggi-do (KR); Lee, Jeongyub, 16678 Suwon-si, Gyeonggi-do (KR); Cho, Eun-Hyoung, 16678 Suwon-si, Gyeonggi-do (KR)
(74) Representative: Grünecker Patent- und Rechtsanwälte PartG mbB

(57) **Abstract**

An interconnect structure including a film including non-single crystalline material, and a ruthenium film positioned on the film and including crystal grains, wherein the crystal grains with <001> orientation of the ruthenium film has a crystal grain texturing factor, *F*₀₀₁, of about 0.7 to 1, and an average crystal grain size of the ruthenium film is about 50 nm to about 200 nm.

## Description

### BACKGROUND

### 1. Field

Interconnect structures and integrated circuit devices are described.

### 2. Description of the Related Art

In order to provide highly integrated, high-performance integrated circuit devices, technologies for reducing the dimensions of circuit devices incorporated into integrated circuit devices are being actively studied, and therefore, there is a demand and need to reduce dimensions of the interconnect structure that electrically connects the circuit devices.

### SUMMARY

An embodiment provides an interconnect structure that may reduce or prevent degradation of electrical characteristics even at reduced dimensions.

Another embodiment provides an integrated circuit device including the interconnect structure.

The invention is what is claimed in the independent claims. Preferred embodiments are specified in the dependent claims.

According to an embodiment, an interconnect structure includes a film including non-single crystalline material, and a ruthenium film positioned on the film and including crystal grains, wherein crystal grains with <001> orientation of the ruthenium film has a crystal grain texturing factor, *F*₀₀₁, of about 0.7 to about 1, and an average crystal grain size of the ruthenium film is about 50 nanometers (nm) to about 200 nm.

The non-single crystalline material may include an amorphous conductor, a polycrystalline conductor, an amorphous semiconductor, a polycrystalline semiconductor, an amorphous dielectric, a polycrystalline dielectric, or a combination thereof.

The interconnect structure may further include a dielectric film positioned on a surface and an opposite surface of the ruthenium film, e.g., surrounding the ruthenium film on at least two sides of the ruthenium film.

The ratio of an intensity of the (002) peak to an intensity of the (101) peak as observed in an X-ray diffraction pattern of the ruthenium film may be about 30:1 to about 100:1.

The intensity of the (002) peak as observed in an X-ray diffraction pattern of the ruthenium film may be about 90% to about 100% of the sum of the intensities of the (100), (101), and (002) peaks in the X-ray diffraction pattern.

A misorientation angle of grain boundaries between adjacent crystal grains of the ruthenium film may be 0 to about 15 degrees with respect to the horizontal direction of the ruthenium film.

The grain boundaries (e.g., most, if not all, of them) between the adjacent crystal grains of the ruthenium film may have a coincidence site lattice.

An average surface roughness of the ruthenium film may be greater than 0 and less than about 1.0 nm.

The ruthenium film may include carbon in an amount of greater than or equal to about 0.01 at% and less than about 0.30 at%.

The carbon may be distributed along grain boundaries between the adjacent crystal grains of the ruthenium film.

The crystal grain texturing factor, *F*₀₀₁, of the crystal grains with <001> orientation of the ruthenium film may be about 0.85 to 1

The crystal grain texturing factor, *F*₀₀₁, of the crystal grains with <001> orientation of the ruthenium film may be about 0.95 to 1, and/or an average crystal grain size of the ruthenium film may be about 80 nm to about 200 nm.

A line width of the ruthenium film may be greater than or equal to about 1 nm and less than about 20 nm.

According to another embodiment, a method of manufacturing an interconnect structure includes providing a ruthenium precursor on a film including a non-single crystalline material to form a ruthenium deposited product, and post-annealing (or referred to as annealing) the ruthenium deposited product to form a ruthenium film, wherein crystal grains with <001> orientation of the ruthenium film has a crystal grain texturing factor, *F*₀₀₁, of about 0.7 to 1, and an average crystal grain size of the ruthenium film is about 50 nm to about 200 nm.

The forming of the ruthenium deposited product and the post-annealing of the ruthenium deposited product may be performed independently at the same or different temperatures at about 220°C to about 550°C.

The ruthenium film may include carbon in an amount of greater than or equal to about 0.01 at% and less than about 0.30 at%.

The ruthenium deposited product may include a greater amount of carbon than the ruthenium film, e.g., the ruthenium deposited product corresponding to a respective ruthenium film may include carbon in an amount of about 0.10 at% to about 1.50 at%.

A crystal grain texturing factor of crystal grains with the <001> orientation, *F*₀₀₁, of the ruthenium deposited product may be less than about 0.6 (e.g., greater than or equal to about 0.2 and less than about 0.6) and the average crystal grain size of the ruthenium deposited product may be greater than or equal to about 1 nm and less than about 20 nm.

At least one of an oxidizing agent or a reducing agent and an inert gas may be provided in the providing of the ruthenium precursor or after the providing of the ruthenium precursor.

The oxidizing agent may include oxygen, ozone, water (in vapor form), or plasma active species derived therefrom, the reducing agent may include hydrogen gas, ammonia gas, or plasma active species derived therefrom, and a partial pressure ratio of at least one of the oxidizing agent or the reducing agent to the inert gas may be about 0.05:1 to about 1:1.

The introduction of the ruthenium precursor may be performed in a number of separate additions, e.g., 1 to 10 additions.

According to another embodiment, an integrated circuit device includes a semiconductor substrate, a circuit device integrated in the semiconductor substrate or positioned on the semiconductor substrate, and a wiring electrically connected to the circuit device and including a ruthenium film including crystal grains, wherein the crystal grains with <001> orientation of the ruthenium film has a crystal grain texturing factor, *F*₀₀₁, of about 0.7 to 1 and an average crystal grain size of the ruthenium film is about 50 nm to about 200 nm.

The integrated circuit device may further include a film positioned under the wiring and including a non-single crystalline material, wherein the non-single crystalline material may include an amorphous conductor, a polycrystalline conductor, an amorphous semiconductor, a polycrystalline semiconductor, an amorphous dielectric, a polycrystalline dielectric, or a combination thereof.

The ruthenium film may include carbon in an amount of greater than or equal to about 0.01 at% and less than about 0.30 at%.

A misorientation angle of grain boundaries between the adjacent crystal grains of the ruthenium film may be 0 to about 15 degrees with respect to the horizontal direction of the ruthenium film, or the grain boundaries (e.g., most, if not all, of them) between the adjacent crystal grains of the ruthenium film may have a coincidence site lattice.

An average surface roughness of the ruthenium film may be greater than 0 and less than about 1.0 nm.

A line width of the ruthenium film may be greater than or equal to about 1 nm and less than about 20 nm.

According to another embodiment, an integrated circuit device includes a semiconductor substrate, a circuit device integrated in the semiconductor substrate or positioned on the semiconductor substrate, a dielectric film positioned on the circuit device and including a trench, and a ruthenium film positioned in the trench and including crystal grains, wherein the crystal grains with <001> orientation are the most among the crystal grains of the ruthenium film, and a misorientation angle of grain boundaries between adjacent crystal grains of the ruthenium film is 0 to about 15 degrees with respect to the horizontal direction of the ruthenium film, or grain boundaries (e.g., most, if not all, of them) between the adjacent crystal grains of the ruthenium film has a coincidence site lattice.

The crystal grains with <001> orientation of the ruthenium film may be account for greater than 90%, e.g., about 95 to 100%, of the crystal grains, an average crystal grain size of the ruthenium film may be about 80 nm to about 200 nm, and an average surface roughness of the ruthenium film may be greater than 0 and less than about 1.0 nm.

### BRIEF DESCRIPTION OF THE DRAWINGS

FIG. 1 is a cross-sectional view showing an example of an interconnect structure according to one embodiment.
FIGS. 2 to 5 are schematic views each showing an example of a method of manufacturing an interconnect structure according to one embodiment.
FIGS. 6 to 9 are schematic views each showing an example of a method of manufacturing an interconnect structure according to one embodiment.
FIG. 10 is a cross-sectional view showing a three-dimensional logic device as an example of an integrated circuit device according to one embodiment.
FIG. 11 is a conceptual view showing an example of an electronic device according to an embodiment.
FIG. 12 is an atomic probe tomography (APT) analysis showing the carbon distribution in the Ru deposited product according to Example 2.
FIG. 13 is a graph showing the carbon concentration according to a position in the Ru deposited product in the APT analysis of FIG. 12.
FIG. 14 is an APT analysis showing the carbon distribution in the Ru film according to Example 2.
FIG. 15 is a graph showing the carbon concentration according to a position in the Ru film in the APT analysis of FIG. 14,
FIGS. 16A and 16B are precession electron diffraction (PED) orientation maps along the z-axis direction (the direction perpendicular to the substrate surface) of the Ru deposited product and the Ru film according to Example 1, respectively.
FIGS. 17A and 17B are PED orientation maps along the z-axis direction of the Ru deposited product and the Ru film according to Example 2, respectively.
FIGS. 18A and 18B are PED orientation maps along the z-axis direction of the Ru deposited product and the Ru film according to Example 3, respectively.
FIGS. 19A and 19B are PED orientation maps along the z-axis direction of the Ru deposited product and the Ru film according to Example 4, respectively.
FIGS. 20A and 20B are PED orientation maps along the z-axis direction of the Ru deposited product and the Ru film according to Reference Example 1, respectively.
FIG. 21 is an XRD pattern measured at a normal angle of the Ru deposited product and the Ru film according to Example 2.
FIG. 22 is an XRD pattern measured at a normal angle of the Ru deposited product and the Ru film according to Reference Example 1.
FIG. 23 is an XRD pattern measured at a low-angle (0.5 degree relative to the substrate surface) glancing angle incidence of the Ru deposited product and the Ru film according to Example 2.
FIG. 24 is an XRD pattern measured at a low-angle (0.5 degree relative to the substrate surface) glancing angle incidence of the Ru deposited product and the Ru film according to Reference Example 1.
FIG. 25 is a TEM image showing the grain boundaries of the Ru film according to Example 2.
FIG. 26 is a TEM image showing the grain boundaries of the Ru film according to Reference Example 2.
FIGS. 27A and 27B are PED orientation maps along the z-axis direction (the direction perpendicular to the substrate surface) and the x-axis direction (the direction parallel to the substrate surface) of the Ru film according to Example 2, respectively.
FIGS. 28A and 28B are PED orientation maps along the z-axis and x-axis directions of the Ru film according to Reference Example 1, respectively.
FIGS. 29A and 29B are PED orientation maps along the z-axis and x-axis directions of the Ru film according to Reference Example 2, respectively.
FIG. 30 is a graph showing the change in resistivity according to the thickness (line width) of the Ru films according to Example 2 and Reference Examples 1 and 2.

### DETAILED DESCRIPTION

Hereinafter, the embodiments will be described in detail so that those of ordinary skill in the art may easily implement them. However, the actually applied structure may be implemented in several different forms and is not limited to the embodiments described herein.

The terminology used herein is used to describe embodiments only, and is not intended to limit the present disclosure. As used herein, the singular forms "a," "an," and "the" are intended to include the plural forms, including "at least one," unless the content clearly indicates otherwise. Therefore, reference to "an" element in a claim followed by reference to "the" element is inclusive of one element as well as a plurality of the elements.

"At least one" is not to be construed as limiting "a" or "an." "Or" means "and/or." As used herein, the term "and/or" includes any and all combinations of one or more of the associated listed items.

It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

In the drawings, the thickness of layers, films, panels, regions, etc., are exaggerated for clarity. Like reference numerals designate like elements throughout the specification. It will be understood that when an element such as a layer, film, region, or substrate is referred to as being "on" another element, it may be directly on the other element or intervening elements may also be present. In contrast, when an element is referred to as being "directly on" another element, there are no intervening elements present.

The drawings and description are to be regarded as illustrative in nature and not restrictive. Like reference numerals designate like elements throughout the specification.

It will be understood that when a component is referred to as being "on" or "above" another component, the component may be directly on, under, on the left of, or on the right of the other component, or may be on, under, on the left of, or on the right of the other component in a non-contact manner.

The term "layer" or "film" includes a construction having a shape formed on a part of a region, in addition to a construction having a shape formed on an entire region.

As used herein, the term "the" or similar indicative terms correspond to both the singular form and the plural form. The steps of all methods described herein may be performed in any suitable order unless otherwise indicated herein or otherwise clearly contradicted by context.

Hereinafter, unless otherwise defined, "substantially" or "approximately" or "about" includes not only the stated value, but also the average within an allowable range of deviation, considering the error associated with the measurement and amount of the measurement. For example, "substantially" or "approximately" may mean within ±10%, ±5%, ±3%, or ±1% of the indicated value or within a standard deviation.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, "metal" is interpreted as a concept including metals and metalloids (semimetals).

An embodiment provides an interconnect structure that may reduce or prevent degradation of electrical characteristics even at reduced dimensions.

An interconnect structure according to an embodiment is described. The interconnect structure may be a structure that provides a path for electrically connecting two or more circuit devices in a semiconductor device such as an integrated circuit device, and may include a via or a wiring. However, if the dimensions of the interconnect structure are reduced below a certain range, the resistance may increase rapidly due to material limitations, which may deteriorate the electrical characteristics.

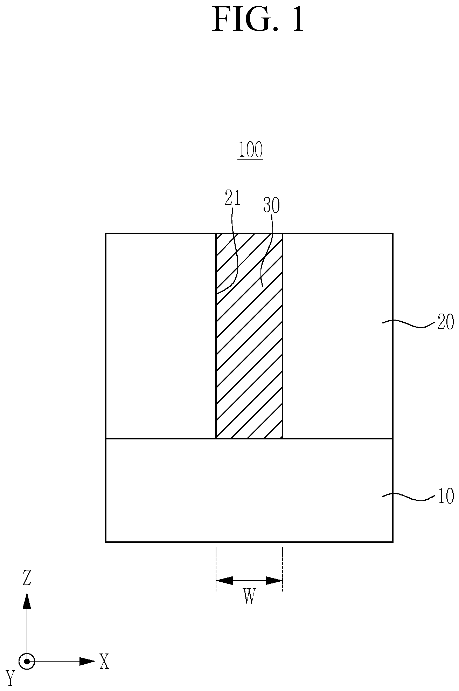

FIG. 1 is a cross-sectional view showing an example of an interconnect structure according to an embodiment. Referring to FIG. 1, the interconnect structure 100 includes a film 10, a dielectric film 20, and a ruthenium (Ru) film 30. As shown, the film 10 may be positioned under the Ru film 30 and a surface of film 10 may face a surface, e.g., a lower surface, of the Ru film 30. For example, the film 10 may be in contact with a lower surface of the Ru film 30.

The film 10 may include a non-single crystalline material (a non-monocrystalline material), and may include a non-single crystalline conductor, a non-single crystalline semiconductor, a non-single crystalline dielectric, or a combination thereof. For example, the film 10 may include an amorphous conductor, a polycrystalline conductor, an amorphous semiconductor, a polycrystalline semiconductor, an amorphous dielectric, a polycrystalline dielectric, or a combination thereof.

When the film 10 includes an amorphous conductor, a polycrystalline conductor, an amorphous semiconductor, or a polycrystalline semiconductor, the film 10 may be a contact conductive film or a contact semiconductor film that is electrically connected to the Ru film 30. The contact conductive film may be, for example, a contact metal film including a metal such as copper Cu, aluminum Al, cobalt Co, tungsten W, molybdenum Mo, an alloy thereof, or a combination thereof. The contact semiconductor film may be a contact semimetal film including, for example, an impurity-doped semimetal (e.g., silicon), but is not limited thereto.

When the film 10 includes an amorphous dielectric or a polycrystalline dielectric, the film 10 may be an interlayer dielectric (ILD) or an intermetal dielectric (IMD), and may include a dielectric material that is the same as or different from the dielectric film 20. When the film 10 and dielectric film 20 include the same dielectric material, the film 10 and dielectric film 20 may be a continuous film.

The dielectric film 20 may include a dielectric material having a dielectric constant of, for example, about 4.0 or less, and may include, for example, a metal oxide, a semimetal oxide, a carbon-doped metal oxide, a carbon-doped semimetal oxide, a metal carbide, a semimetal carbide, a hydrogenated metal carbide, a hydrogenated semimetal carbide, a metal nitride, a semimetal nitride, a carbon-doped metal nitride, a carbon-doped semimetal nitride, a metal oxynitride, a semimetal oxynitride, a carbon-doped metal oxynitride, a carbon-doped semimetal oxynitride, or a combination thereof.

The dielectric film 20 may include, for example, silicon oxide, silicon nitride, silicon oxynitride, silicon carbonate, silicon carbonitride, aluminum oxide, aluminum nitride, aluminum silicon oxide, aluminum silicon nitride, zirconium oxide, hafnium oxide, boron nitride, or combinations thereof, but is not limited thereto.

The dielectric film 20 (i.e., prior to the deposition of the ruthenium film) may have one or more trenches or via holes 21 (hereinafter, Applicant will refer to both a trench and a via hole as "trench" with an understanding that a person of ordinary skill understands the structural or functional difference in the two types of interconnect structures). Accordingly, a trench 21 may be any space to be filled with the Ru film 30 described later, and the internal shape of the trench 21 may be substantially the same as the shape of the Ru film 30.

Applicant describes a space to be filled with a ruthenium film as a trench with an understanding that a similar description can be applied to filling a via hole with ruthenium film. The trench 21 may have a relatively narrow width W (or relatively small diameter), and the width W of the trench 21 may be substantially the same as the line width W of the Ru film 30 described later. The width W of the trench 21 may be, for example, less than about 20 nm, and within the range, may be about 18 nm or less, about 15 nm or less, about 12 nm or less, about 10 nm or less, for example, about 9 nm or less, about 8 nm or less, about 7 nm or less, about 6 nm or less, about 5 nm or less, about 4 nm or less, or about 3 nm or less, and within the range may be greater than or equal to about 1 nm and less than about 20 nm, about 1 nm to about 18 nm, about 1 nm to about 15 nm, about 1 nm to about 12 nm, about 1 nm to about 10 nm, about 1 nm to about 9 nm, about 1 nm to about 8 nm, about 1 nm to about 7 nm, about 1 nm to about 6 nm, about 1 nm to about 5 nm, about 1 nm to about 4 nm, or about 1 nm to about 3 nm.

The trench 21 may have a relatively high aspect ratio. Herein, the aspect ratio may be a ratio of the depth or thickness to the width. The aspect ratio of the trench 21 may be substantially equal to the aspect ratio of the Ru film 30. The aspect ratio of the trench 21 may be about 3 or greater, about 5 or greater, about 7 or greater, or about 10 or greater, and within the range, may be about 3 to about 50, about 3 to about 45, about 3 to about 40, about 3 to about 35, about 3 to about 30, about 5 to about 50, about 5 to about 45, about 5 to about 40, about 5 to about 35, about 5 to about 30, about 7 to about 50, about 7 to about 45, about 7 to about 40, about 7 to about 35, about 7 to about 30, about 10 to about 50, about 10 to about 45, about 10 to about 40, about 10 to about 35, or about 10 to about 30. The trench 21 may be narrow and deep by having a high aspect ratio within the range.

The Ru film 30 may be embedded in trench 21 of the dielectric film 20 and may be used as a wiring or a via (hereinafter, both are referred to as 'wiring') in a semiconductor device (e.g., an integrated circuit device). The Ru film 30 may be a three-dimensional structure with a width (W), a length, and a thickness, wherein the length direction (e.g., Y direction) of the Ru film 30 may be a direction in which electrons move, the width direction (e.g., X direction) may be a direction perpendicular to the length direction in an in-plane, and the thickness (or depth) direction (e.g., Z direction) may be a direction perpendicular to the surface of the film 10 and perpendicular to the length direction and the width direction, respectively.

The Ru film 30 may have a fine line width W of less than about 20 nm, and within the range, may have a line width of about 18 nm or less, about 15 nm or less, about 12 nm or less, about 10 nm or less, about 9 nm or less, about 8 nm or less, about 7 nm or less, about 6 nm or less, about 5 nm or less, about 4 nm or less, about 3 nm or less, and greater than or equal to about 1 nm and less than about 20 nm, about 1 nm to about 18 nm, about 1 nm to about 15 nm, about 1 nm to about 12 nm, about 1 nm to about 10 nm, about 1 nm to about 9 nm, about 1 nm to about 8 nm, about 1 nm to about 7 nm, about 1 nm to about 6 nm, about 1 nm to about 5 nm, about 1 nm to about 4 nm, or about 1 nm to about 3 nm.

The Ru film 30 may include ruthenium (Ru) or Ru alloy, and may be a polycrystalline conductive film with crystal grains. The Ru film 30 may have for example, a hexagonal close-packed (HCP) crystal structure, but is not limited thereto. The Ru film 30 may be formed by a deposition such as atomic layer deposition (ALD) or chemical vapor deposition (CVD), and thus may be effectively formed with the fine line width described above.

The Ru or Ru alloy of the Ru film 30 may be obtained by a deposition such as an ALD or a CVD and further being post-annealed at a relatively low temperature. Herein, the Ru or Ru alloy formed by the deposition such as an ALD or a CVD before being post-annealed is referred to as "ruthenium deposited product (Ru deposited product)" or "as-deposited Ru film".

The ALD or CVD is a process of nucleating crystals in the Ru deposited product and may induce a desirable crystallographic orientation of the crystal grains in the Ru deposited product. The post-annealing may be a process of rearranging and growing atoms in the Ru deposited product through a recrystallization process to increase crystallinity and crystallographic orientation of crystal grains. The post-annealed Ru film 30 may have improved film quality compared to a non-annealed Ru deposited product. The improved film quality may be due to the crystallographic orientation of crystal grains, a decrease of the number of grain boundaries, and/or a smooth surface, and due to such improved film quality, the Ru film 30 with a fine line width of less than about 20 nm (e.g., about 15 nm or less or about 10 nm or less) may effectively reduce electron scattering at the surface and/or grain boundaries, thereby exhibiting improved electrical characteristics.

As a Ru precursor for the ALD or CVD, an organometallic compound including Ru may be used, and the Ru deposited product and the Ru film 30 may include carbon derived from the Ru precursor. Alternatively, a carbon promoter may be additionally supplied in the ALD or CVD, and the Ru deposited product and the Ru film 30 may include carbon derived from the carbon promoter. Most of the carbon remaining in the Ru deposited product and/or ultimately remaining in the Ru film 30 after the post-annealing may be distributed or segregated along grain boundaries between adjacent crystal grains.

For example, carbon distributed at the grain boundaries of the Ru deposited product in the deposition may effectively control the crystallographic orientation of the crystal grains in the Ru deposited product, thereby inducing a desirable crystallographic orientation, and may provide a basis for reinforcing the preferred crystallographic orientation during the subsequent post-annealing (recrystallization process). This may be expected because a predetermined amount of carbon distributed or segregated at the grain boundaries of the Ru deposited product may control the surface energy of the crystal grains to capture and diffuse more atoms into a preferred direction, thereby controlling the crystallographic orientation, but is not limited to a specific theory.

For example, during the post-annealing (recrystallization process), some of the carbon distributed or segregated along the grain boundaries in the Ru deposited product may be released, thereby facilitating atomic migration and coalescence, and thereby expanding the crystal grains and increasing their size, while further aligning the crystallographic orientation of the Ru film 30 laterally and vertically.

Control of the crystal grain size and crystallographic orientation of the Ru film 30 may be determined depending on the amount of residual carbon in the Ru deposited product and/or the Ru film 30. The amount of residual carbon in the Ru deposited product may be, for example, about 1.50 at% or less, and within the range, may be about 0.10 to about 1.50 at%, about 0.10 to about 1.40 at%, about 0.10 to about 1.30 at%, about 0.10 to about 1.20 at%, about 0.20 to about 1.50 at%, about 0.20 to about 1.40 at%, about 0.20 to about 1.30 at%, or about 0.20 to about 1.20 at%. When the Ru deposited product includes carbon within the range, the crystallographic orientation of the crystal grains in the Ru deposited product may be effectively controlled. The amount of residual carbon in the Ru deposited product may be controlled by adjusting the substrate temperature (process temperature), deposition pressure, and/or partial pressure of the co-reactant (e.g., oxygen partial pressure) during deposition. For example, as the substrate temperature (process temperature) increases, the deposition pressure decreases, and/or the partial pressure of the co-reactant (e.g., oxygen partial pressure) decreases, the amount of residual carbon may be effectively reduced.

The amount of residual carbon in the Ru film 30 after the post-annealing may be less than the amount of carbon in the Ru deposited product, for example, the Ru film 30 may include less than about 0.30 at% of carbon, and within the range may include about 0.28 at% or less, about 0.25 at% or less, about 0.22 at% or less, about 0.20 at% or less, or about 0.19 at% or less of carbon, and within the range, may include greater than or equal to about 0.01 at% and less than about 0.30 at% of carbon. The amount of residual carbon in the Ru film 30 after the post-annealing may be about 0.01 at% to about 0.28 at%, about 0.01 at% to about 0.25 at%, about 0.01 at% to about 0.22 at%, about 0.01 at% to about 0.20 at%, about 0.01 at% to 0.19 at%, greater than or equal to about 0.05 at% and less than about 0.30 at%, about 0.05 at% to about 0.28 at%, about 0.05 at% to about 0.25at%, about 0.05 at% to about 0.22 at%, about 0.05 at% to about 0.20 at%, or about 0.05 at% to about 0.19 at%.

The amount of residual carbon in the Ru film 30 after the post-annealing may be greater than or equal to about 0.10 at% and less than about 0.30at%, about 0.10 at% to about 0.28 at%, about 0.10 at% to about 0.25 at%, about 0.10 at% to about 0.22 at%, about 0.10 at% to about 0.20 at%, or about 0.10 at% to 0.19 at%. When the Ru film 30 includes carbon in the above range, the crystal grain size may be effectively increased while further reinforcing preferred crystallographic orientation of the Ru film 30.

For example, most of the crystal grains forming the Ru film 30 may be aligned in a direction perpendicular (hereinafter referred to as the 'vertical direction') to the surface (horizontal plane of the crystal grains) of the film 10 by including carbon in the above range. For example, most of the crystal grains of the Ru film 30 may be aligned in the <001> orientation, where the <001> orientation may be the c-axis direction. The ratio of an area of crystal grains aligned in the <001> orientation to the area of the crystal grains of the Ru film 30 may be about 70% to 100%, and within the range, may be about 75% to 100%, about 80% to 100%, about 85% to 100%, about 90% to about 100%, about 95% to 100%, about 97% to 100%, about 98% to 100%, or about 99% to 100%.

The degree to which crystal grains are aligned in one orientation may be expressed by a crystal grain texturing factor (F) (or Lotgering degree of orientation), and the crystal grain texturing factor may be a ratio of the area of crystal grains aligned in a predetermined orientation to the area occupied by the crystal grains. When the ratio of the area of crystal grains aligned in the <001> orientation to the area of the crystal grains is expressed as a crystal grain texturing factor, *F*₀₀₁, may be about 0.70 to 1, about 0.75 to 1, about 0.80 to 1, about 0.85 to 1, about 0.90 to 1, about 0.95 to 1, about 0.97 to 1, about 0.98 to 1, or about 0.99 to 1.

Herein, the crystal grain texturing factor may be measured from the ratio of the area occupied by crystal grains with the <001> orientation to the total area of the crystal grains observed in an image such as the transmission electron microscopy (TEM) image and/or the precession electron diffraction orientation map (PED orientation map). For example, it may be measured from the ratio of the area occupied by crystal grains with the <001> orientation in an image of 500 nm × 500 nm area or in an image of a corresponding area thereof. When the Ru film 30 is included in the wiring or via of a device such as an integrated circuit device, the crystal grain texturing factor (*F*₀₀₁) of the Ru film 30 in the device may be measured from the ratio of the area occupied by crystal grains with the <001> orientation in an image (a TEM image and/or PED orientation map) corresponding to a specified area (for example, 500 nm (line width) × 500 nm (length)) of the cross-section of the Ru film 30. For example, when the line width of the wiring or via is about 10 nm, it may be measured from the ratio of the area occupied by crystal grains with the <001> orientation in an image of about 10 nm line width and about 25 µm length (10 nm x 25 µm) corresponding to the area defined by about 500 nm line width and about 500 nm length (500 nm x 500 nm).

The orientation of the crystal grains forming Ru film 30 may be confirmed by an X-ray diffraction (XRD) pattern (or spectrum). For example, in the XRD pattern of the Ru film 30, the (002) peak (2θ=42.3 degrees) corresponding to the <001> orientation may be predominantly observed, and the intensity of the (002) peak corresponding to the <001> orientation may account for about 90% or more, about 92% or more, about 95% or more, about 97% or more, about 98% or more, about 99% or more, about 99.5% or more, or 100% of the sum of the intensities of the (100) peak (2θ=38.5 degrees), the (101) peak (2θ=44.2 degrees), and the (002) peak. For example, in the XRD pattern of the Ru film 30, the (100) peak and the (101) peak may not be substantially observed.

For example, the ratio of the intensity of the (002) peak to the intensity of the (101) peak observed in the XRD pattern of the Ru film 30 may be about 30 or greater, and within the range, may be about 33 or greater, about 35 or greater, about 37 or greater, or about 40 or greater, and within the range, may be about 30 to about 100, about 33 to about 100, about 35 to about 100, about 37 to about 100, or about 40 to about 100.

For example, no peak may be observed in the grazing incidence (or glancing angle incidence) XRD pattern at an incident angle of about 0.5 degrees of the Ru film 30. The grazing incidence XRD pattern is an analyzing method of the crystal structure of a surface by incident light at an angle smaller than about 10 degrees with respect to the horizontal direction, and the absence of observation of a peak may mean that most of the crystal grains of the Ru film 30 are aligned in the <001> orientation, which is perpendicular to the surface (horizontal plane of the crystal grains) of the film 10.

For example, the Ru film 30 may have a decreased misorientation between the adjacent crystal grains arranged along the direction parallel to the surface (horizontal plane of crystal grains) of the film 10 by including carbon in the above range, and the orientation of grain boundaries in the horizontal direction may be effectively controlled. This orientation of grain boundaries in the horizontal direction may be confirmed by the misorientation angle (or tilt angle) of the grain boundaries between adjacent crystal grains, and herein, the misorientation angle of the grain boundaries may be the angle of change required to match or coincide with adjacent crystal grains.

The misorientation angle of the grain boundaries between the adjacent crystal grains of the Ru film 30 may be about 15 degrees or less with respect to the horizontal direction of Ru film 30 (or the in-plane direction of the Ru film 30). Herein, the misorientation angle of the grain boundaries of the Ru film 30 may be evaluated through transmission electron microscopy (TEM) analysis. Within the above range, the misorientation angle of the grain boundaries between adjacent crystal grains may be 0 degrees to about 15 degrees, 0 degrees to about 13 degrees, 0 degrees to about 10 degrees, 0 degrees to about 7 degrees, or 0 degrees to about 5 degrees.

For example, the misorientation angle of the grain boundaries between adjacent crystal grains may be about 0.2 degrees to about 15 degrees, about 0.2 degrees to about 13 degrees, about 0.2 degrees to about 10 degrees, about 0.2 degrees to about 7 degrees, or about 0.2 degrees to about 5 degrees.

By controlling the misorientation angle of the grain boundaries in the Ru film 30 within the above range, electron scattering at the grain boundaries may be effectively reduced, and accordingly, a rapid increase in resistance due to electron scattering at the grain boundaries in the Ru film 30 with a fine line width of about 20 nm or less (e.g., about 15 nm or less, or about 10 nm or less) may be effectively reduced or prevented.

Most if not all, of the grain boundaries of the Ru film 30 may have a coincidence site lattice CSL. The CSL refers to a lattice structure in which the crystal lattices of two adjacent crystal grains are rotated by a predetermined angle so that some lattice points coincide, and may represent the symmetry of the crystal grains of the Ru film 30. For example, in a case where adjacent crystal grains have different crystal orientations from each other (for example, in a case where crystal grains having (001), (110), and (011) orientations are arranged adjacent to each other), the crystal grains do not have symmetry, and thus the CSL may not be present. The CSL may be expressed by sigma (ΣX, where X is a natural number), and ΣX is a ratio of the number of lattice points in a unit cell of the CSL to the number of lattice points in a unit cell of the basic lattice, for example, Σ3 may mean that three lattice points coincide by rotating two crystal lattices. The Ru film 30 may have the CSL, such as Σ7, Σ13, Σ19, and/or Σ31. Herein, the CSL of the Ru film 30 may be evaluated through transmission electron microscope (TEM) analysis.

As described above, most of the crystal grains of the Ru film 30 are predominantly aligned in the <001> orientation, which is the vertical direction, and the orientation (misorientation angle) of the grain boundaries between the adjacent crystal grains in the horizontal direction is effectively controlled, so that the surface roughness of the Ru film 30 may be relatively low. The average surface roughness of the Ru film 30 may be less than about 1.0 nm, and within the range, may be about 0.9 nm or less, about 0.8 nm or less, about 0.7 nm or less, about 0.6 nm or less, or about 0.5 nm or less, and within the range, greater than 0 and less than about 1 nm, greater than 0 and about 0.9 nm or less, greater than 0 and about 0.8 nm or less, greater than 0 and about 0.7 nm or less, greater than 0 and about 0.6 nm or less, greater than 0 and about 0.5 nm or less, greater than or equal to about 0.01 nm and less than about 1 nm, about 0.01 nm to about 0.9 nm, about 0.01 nm to about 0.8 nm, about 0.01 nm to about 0.7 nm, about 0.01 nm to about 0.6 nm, about 0.01 nm to about 0.5 nm, about 0.1 nm to about 0.9 nm, about 0.1 nm to about 0.8 nm, about 0.1 nm to about 0.7 nm, about 0.2 nm to about 0.6 nm, or about 0.3 nm to about 0.5 nm. Herein, the average surface roughness may be Arithmetic Average Roughness (Ra).

For example, Ru film 30 may be grown into including relatively uniformly large crystal grains by including carbon in the above range. As described above, during the post-annealing (recrystallization process), some of the carbon in the Ru deposited product may be released, which may migrate the grain boundaries and expand the crystal grains, and as a result, the size of the crystal grains may increase.

The average crystal grain size of Ru film 30 may be greater than or equal to about 50 nm, and within the above range, may be greater than or equal to about 55 nm, greater than or equal to about 60 nm, greater than or equal to about 70 nm, greater than or equal to about 80 nm, greater than or equal to about 90 nm, or greater than or equal to about 100 nm, and within the above range, may be about 50 nm to about 200 nm, about 55 nm to about 200 nm, about 60 nm to about 200 nm, about 70 nm to about 200 nm, about 80 nm to about 200 nm, about 90 nm to about 200 nm, about 100 nm to about 200 nm, about 50 nm to about 180 nm, about 55 nm to about 180 nm, about 60 nm to about 180 nm, about 70 nm to about 180 nm, about 80 nm to about 180 nm, about 90 nm to about 180 nm, about 100 nm to about 180 nm, about 50 nm to about 160 nm, about 55 nm to about 160 nm, about 60 nm to about 160 nm, about 70 nm to about 160 nm, about 80 nm to about 160 nm, about 90 nm to about 160 nm, about 100 nm to about 160 nm, about 50 nm to about 150 nm, about 55 nm to about 160 nm, about 60 nm to about 150 nm, about 70 nm to about 150 nm, about 80 nm to about 150 nm, about 90 nm to about 150 nm, about 100 nm to about 150 nm, about 50 nm to about 140 nm, about 55 nm to about 140 nm, about 60 nm to about 140 nm, about 70 nm to about 140 nm, about 80 nm to about 140 nm, about 90 nm to about 140 nm, about 100 nm to about 140 nm, about 50 nm to about 130 nm, about 55 nm to about 130 nm, about 60 nm to about 130 nm, about 70 nm to about 130 nm, about 80 nm to about 130 nm, about 90 nm to about 130 nm, about 100 nm to about 130 nm, about 50 nm to about 115 nm, about 55 nm to about 115 nm, about 60 nm to about 115 nm, about 70 nm to about 115 nm, about 80 nm to about 115 nm, about 90 nm to about 115 nm, or about 100 nm to about 115 nm.

Herein, the average crystal grain size of the Ru film 30 may be determined by averaging the sizes of crystal grains observed in an image, for example TEM image and/or PED orientation maps of the Ru film 30. For example, it may be determined by averaging the sizes of crystal grains observed in an image of 500 nm × 500 nm area or in an image of a corresponding area thereof. When the Ru film 30 is included in the wiring or via of a device such as an integrated circuit device, the average crystal grain size of the Ru film 30 in the device may be determined by averaging the sizes of crystal grains observed in an image (a TEM image and/or PED orientation map) corresponding to a specified area (for example, 500 nm (line width) × 500 nm (length)) of the cross-section of the Ru film 30. For example, when the line width of the wiring or via is about 10 nm, the average crystal grain size may be determined by averaging the sizes of crystal grains observed in an image of about 10 nm line width and about 25 µm length (10 nm x 25 µm) corresponding to the area defined by about 500 nm line width and about 500 nm length (500 nm x 500 nm).

In this way, the Ru deposited product and the Ru film 30 may include a predetermined amount of carbon, and thus the crystal grains may be predominantly aligned in the vertical <001> orientation and the horizontal orientation of the grain boundaries between the adjacent crystal grains may be stably controlled, while increasing the size of the crystal grains. Accordingly, the Ru film 30 may have relatively large crystal grains while having uniform and stable orientation in the vertical and horizontal directions, so that electron scattering at the grain boundaries may be effectively reduced, and unlike bulk metals such as copper, a rapid increase in resistance may be effectively reduced or prevented even with a fine line width of less than about 20 nm (e.g., about 15 nm or less, or about 10 nm or less).

For example, with respect to the Ru film 30 with a fine line width of less than about 20 nm, the change in resistivity due to a 10% decrease in line width may be less than about 2 times. In other words, with respect to the Ru film 30 with a fine line width of less than about 20 nm, when the line width decreases by 10%, the resistivity may be less than about 2 times of the original resistivity. Within the above range, the change in resistivity of the Ru film 30 due to a 10% decrease in a line width may be about 1 to 1.8 times, about 1 to 1.6 times, or about 1 to 1.4 times. In addition, with respect to the Ru film 30 with a fine line width of less than about 20 nm, the change in resistivity due to a 20%, 30%, 40%, 50%, 60% or 70% decrease in line width may be less than about 2 times, for example, may be about 1 to 1.8 times, about 1 to 1.6 times, or about 1 to 1.4 times.

For example, with respect to the Ru film 30 with a fine line width of less than about 20 nm, the resistivity of the Ru film 30 may be about 15 µΩ • cm or less, and within the above range, may be about 13 µΩ • cm or less, about 12 µΩ • cm or less, or about 10 µΩ • cm or less, and within the range, may be about 3 µΩ • cm to about 15 µΩ • cm, about 3 µΩ • cm to about 13 µΩ • cm, about 3 µΩ • cm to about 12 µΩ • cm, about 3 µΩ • cm to about 10 µΩ • cm, about 5 µΩ • cm to about 15 µΩ • cm, about 5 µΩ • cm to about 13 µΩ • cm, about 5 µΩ • cm to about 12 µΩ • cm, or about 5 µΩ • cm to about 10 µΩ • cm.

The Ru film 30 described above may have stable vertical and horizontal orientation, decreased grain boundaries, and relatively large crystal grains, without using a single crystal substrate (e.g., a sapphire substrate) or a physical vapor deposition method (e.g., sputtering) that requires a high temperature of about 1000° C. or higher, and thus may effectively reduce electron scattering at the surface and grain boundaries even with a fine line width of less than about 20 nm (e.g., about 15 nm or less, or about 10 nm or less), thereby maintaining stable electrical characteristics without a rapid change in resistivity. Accordingly, in a semiconductor device in which a plurality of circuit devices are stacked, it is possible to overcome limitations such as a film (a non-single crystalline film) and a process temperature, and effectively apply the Ru film 30 described above and an interconnect structure 100 including the same.

An example of a method of manufacturing an interconnect structure according to an embodiment is described.

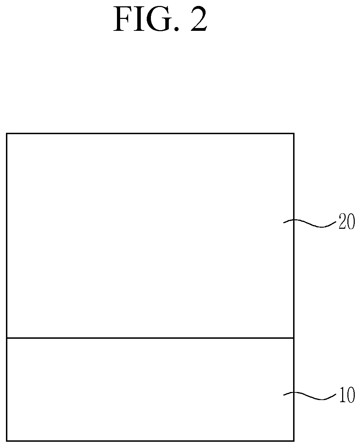

FIGS. 2 to 5 are schematic views showing of the steps in a method of manufacturing of an interconnect structure according to one embodiment.

An example of a method of manufacturing an interconnect structure according to an embodiment includes forming a dielectric film 20 on a film 10, forming a trench or via hole 21 (hereinafter referred to as a "trench") in the dielectric film 20, forming a Ru deposited product 30a in the trench 21, and post-annealing the Ru deposited product 30a to form a Ru film 30. Referring to FIG. 2, the dielectric film 20 is formed on the film 10.

The film 10 may include a non-single crystalline material, such as an amorphous conductor, a polycrystalline conductor, an amorphous semiconductor, a polycrystalline semiconductor, an amorphous dielectric, a polycrystalline dielectric, or a combination thereof. For example, the film 10 may include a contact metal layer including a metal such as Cu, Al, Co, W, Mo, an alloy thereof, or a combination thereof; a contact semimetal layer including, for example, an impurity-doped semimetal (e.g., silicon); or a dielectric layer including silicon oxide, silicon nitride, silicon oxynitride, silicon carbonate, silicon carbonitride, aluminum oxide, aluminum nitride, aluminum silicon oxide, aluminum silicon nitride, zirconium oxide, hafnium oxide, boron nitride, or a combination thereof.

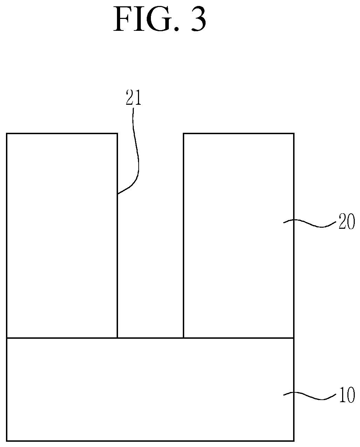

Referring to FIG. 3, the dielectric film 20 is patterned to form the trench 21. The trench 21 may have a narrow and deep shape, and may have, for example, a width of less than about 20 nm and an aspect ratio of about 3 or more. The width of the trench 21 may be about 18 nm or less, about 15 nm or less, about 12 nm or less, about 10 nm or less, about 9 nm or less, about 8 nm or less, about 7 nm or less, about 6 nm or less, about 5 nm or less, about 4 nm or less, or about 3 nm or less, and within the range, may be greater than or equal to about 1 nm and less than about 20 nm, about 1 nm to about 18 nm, about 1 nm to about 15 nm, about 1 nm to about 12 nm, about 1 nm to about 10 nm, about 1 nm to about 9 nm, about 1 nm to about 8 nm, about 1 nm to about 7 nm, about 1 nm to about 6 nm, about 1 nm to about 5 nm, about 1 nm to about 4 nm, or about 1 nm to about 3 nm.

The aspect ratio of the trench 21 may be within the range of about 3 to about 50, about 3 to about 45, about 3 to about 40, about 3 to about 35, about 3 to about 30, about 5 to about 50, about 5 to about 45, about 5 to about 40, about 5 to about 35, or about 5 to about 30. The patterning may be performed by, for example, a photolithography process, but is not limited thereto.

Optionally, a deposition inhibiting layer (not shown), a barrier layer (not shown), and/or a liner (not shown) may be additionally formed on the inner wall of the dielectric film 20 within the trench 21. The deposition inhibiting layer may include, for example, a silane compound, a siloxane compound, a silazane compound, or a combination thereof, but is not limited thereto. The barrier layer and/or the liner may include, for example, a metal, a semimetal, a metal alloy, a metal nitride, a semimetal nitride, or a combination thereof, and may include, for example, tantalum Ta, titanium Ti, cobalt Co, tungsten W, silicon Si, a nitride thereof, or a combination thereof, but is not limited thereto.

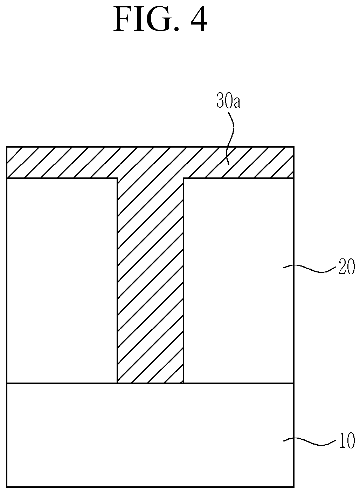

Referring to FIG. 4, the Ru deposited product 30a is formed inside the trench 21 and on the dielectric film 20. The Ru deposited product 30a may be formed by, for example, a deposition such as atomic layer deposition (ALD) or chemical vapor deposition (CVD). Herein, a method of forming the Ru deposited product 30a by ALD is described as an example, but is not limited thereto.

Referring to FIG. 3, the deposition may be performed by placing a substrate including the film 10 in a deposition chamber (not shown) and supplying at least one ruthenium precursor (Ru precursor) as a reactant. The deposition may be performed at a temperature of about 550° C or less under a process pressure (a deposition pressure or a chamber pressure) of 10 Torr or less, and may be performed at a temperature within the range of about 500° C or less, or about 450° C or less, and within the range, may be performed at a temperature about 220° C to about 550° C, about 220° C to about 500° C, about 220° C to about 450° C, about 250° C to about 550° C, about 250° C to about 500° C, about 250° C to about 450° C, about 300° C to about 550° C, about 300° C to about 500° C, about 300° C to about 450° C, about 350° C to about 550 ° C, about 350° C to about 500° C, or about 350° C to about 450° C.

The Ru precursor may include, for example, an organometallic compound, such as an (arene)(diene)Ru(0) such as (ethylbenzene)(1-ethyl-1,4-cyclohexadiene)Ru(0), (1-isopropyl-4-methylbenzene)(1,3-cyclohexadiene)Ru(0); an (arene)(triene)Ru(0) such as (benzene)(1,3,5-cycloheptatriene)Ru(0); a (diene)(CO)₃Ru(0) such as (2,3-dimethyl-1,3-butadiene)Ru(0)tricarbonyl, (1,3-cyclohexadiene)Ru(0)tricarbonyl; a (triene)(CO) ₃ Ru(0) such as (1,3,5-cycloheptatriene) Ru(0)tricarbonyl; (cyclopentadienyl)₂Ru(II); (cyclopentadienyl)(CO)₂(R)Ru(II) in which R may be a hydrocarbyl group such as an alkyl group, such as (cyclopentadienyl)(ethyl)Ru(II)dicarbonyl; (pentadienyl)(η5-cyclopentadienyl) Ru(II) such as (2,4-dimethylpentadienyl)(ethylcyclopentadienyl) Ru(II); bis(ethylcyclopentadienyl)ruthenium(II), RuEtCP₂); (Pentadienyl)₂Ru(II) such as bis(2,4-dimethylpentadienyl)Ru(II); (Diketonates)₂(CO)₂ Ru(II) such as bis(2,4-pentanediketonato)Ru(II) dicarbonyl ; (amidinate)₂(CO)₂Ru(II), such as (N,N'-diisopropylacetamidinato) Ru(II)dicarbonyl; tricarbonyl(trimethylenemethane)ruthenium(Ru(TMM)(CO)₃), or a combination thereof.

The Ru precursor may be supplied (or introduced into the chamber) in multiple steps and applied to the substrate, for example, supplied in 1 to 10 times as separate additions, e.g., 1 to 8 times, 1 to 6 times, or 1 to 4 times.

A first purging may be performed by supplying a purge gas into the deposition chamber. The purge gas may include, for example, Ar, He, N₂, Ne, or a mixture thereof, and may be supplied at a flow rate of, for example, about 10 sccm to 2000 sccm. The first purging may remove impurities in the deposition chamber by discharging unreacted substances and/or reaction by-products.

Subsequently, at least one of an oxidizing agent or a reducing agent as co-reactants and an inert gas may be supplied into the deposition chamber. The oxidizing agent may include, for example, oxygen, ozone, water (vapor), or plasma species derived therefrom, and the reducing agent may include, for example, hydrogen gas, ammonia gas, or plasma active species derived therefrom. The inert gas may be, for example, Ar, He, N₂, Ne, or a mixture thereof. The partial pressure ratio of at least one of the oxidizing agent or the reducing agent to the inert gas may be from about 0.05 to 1, and within the range, may be from about 0.1 to about 0.8, from about 0.1 to about 0.6 or from about 0.1 to about 0.5. The volume ratio of the inert gas to at least one of the oxidizing agent or the reducing agent may be from about 95:5 to about 50:50. At least one of the oxidizing agent or the reducing agent and the inert gas may be supplied after the first purging or may be supplied simultaneously with the Ru precursor.

A secondary purging may then be performed by supplying a purge gas into the deposition chamber. The purge gas may include, for example, N₂, Ne, Ar, He, or a mixture thereof, and may be supplied at a flow rate of, for example, about 10 sccm to about 2000 sccm.

The deposition may be performed in one or more cycles to form the Ru deposited product 30a of a desired thickness. For example, the deposition may be performed in 1 to 300 cycles, 5 to 100 cycle, or 5 to 50 cycles, but is not limited thereto.

The Ru deposited product 30a may be a polycrystalline conductor, and the film quality of the Ru deposited product 30a may be different from the film quality of the Ru film 30, which is the final product structure. For example, the Ru deposited product 30a may include carbon derived from the Ru precursor, and the carbon may be primarily distributed or primarily aggregate at the grain boundaries in the Ru deposited product 30a. The amount of carbon in the Ru deposited product 30a may be, for example, about 1.50 at% or less, and within the range, may be about 0.10 to about 1.50 at%, about 0.10 to about 1.40 at%, about 0.10 to about 1.30 at%, about 0.10 to about 1.20 at%, about 0.20 to about 1.50 at%, about 0.20 to about 1.40 at%, about 0.20 to about 1.30 at%, or about 0.20 to about 1.20 at%. As described above, the carbon content in the Ru deposited product 30a may be controlled by adjusting the substrate temperature, the deposition pressure, and/or the partial pressure of the co-reactant (e.g., oxygen partial pressure) during the deposition. For example, the carbon content may be lowered as the substrate temperature increases, the deposition pressure decreases, and/or the partial pressure of the co-reactant (e.g., oxygen partial pressure) decreases.

For example, some of the crystal grains of the Ru deposited product 30a may align in a predetermined orientation. For example, the ratio of the area of the crystal grains aligned in the <001> orientation to the area of the crystal grains of the Ru deposited product 30a may be less than about 60%, and within the range, may be less than or equal to about 55%, less than or equal to about 50%, or less than or equal to about 40%. The ratio of the area of the crystal grains aligned in the <001> orientation to the area of the crystal grains of the Ru deposited product 30a may be greater than or equal to about 1% and less than about 60%, about 1% to about 55%, about 1% to about 50%, about 1% to about 40%, greater than or equal to about 5% and less than about 60%, about 5% to about 55%, about 5% to about 50%, or about 5% to about 40%.

The average crystal grain size of the Ru deposited product 30a may be less than about 20 nm, and within the range, may be less than or equal to about 18 nm, less than or equal to about 16 nm, less than or equal to about 14 nm, less than or equal to about 12 nm, or less than or equal to about 10 nm, and within the range, may be greater than or equal to about 1 nm and less than about 20 nm, about 1 nm to about 18 nm, about 1 nm to about 16 nm, about 1 nm to about 14 nm, about 1 nm to about 12 nm, or about 1 nm to about 10 nm.

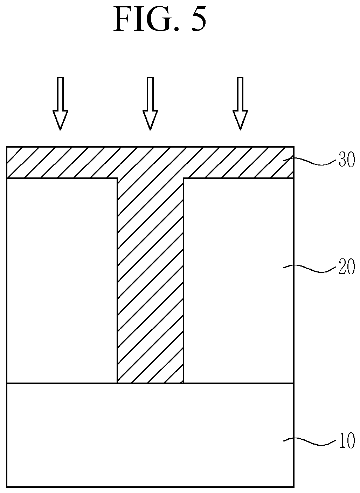

Referring to FIGs. 4 and 5, the Ru deposited product 30a is annealed (post-annealing) to form the Ru film 30. The post-annealing may be performed, for example, under vacuum or vacuum-like conditions. The post-annealing may be performed at a temperature of about 550°C or less. The post-annealing may be performed at a temperature of about 500°C or less or about 450°C or less, and within that range, may be performed at a temperature of about 220°C to about 550°C, about 220°C to about 500°C, about 220°C to about 450°C, about 250°C to about 550°C, about 250°C to about 500°C, about 250°C to about 450°C, about 300°C to about 550°C, about 300°C to about 500°C, about 300°C to about 450°C, about 350°C to about 550°C, about 350°C to about 500°C, or about 350°C to about 450°C.

By post-annealing, some of the carbon distributed along the grain boundaries of the Ru deposited product 30a may be released, and thus, the carbon in the Ru film 30 may be less than the carbon in the Ru deposited product 30a. The amount of the carbon in the Ru film 30 may be, for example, less than about 0.30 at%, and within the range, greater than or equal to about 0.01 at% and less than about 0.30 at%, about 0.01 to about 0.28 at%, about 0.01 to about 0.25 at%, about 0.01 to about 0.22 at%, about 0.01 to about 0.20 at%, about 0.01 to about 0.18 at%, greater than or equal to about 0.05 at% and less than about 0.30 at%, about 0.05 to about 0.28 at%, about 0.05 to about 0.25 at%, about 0.05 to about 0.22 at%, about 0.05 to about 0.20 at%, about 0.05 to about 0.18 at%, greater than or equal to about 0.10 and less than about 0.30 at%, about 0.10 to about 0.28 at%, about 0.10 to about 0.25 at%, about 0.10 to about 0.22 at%, about 0.10 to about 0.20 at%, or about 0.10 to about 0.18 at%.

By post-annealing, the crystal grains of the Ru film 30 may be rearranged and/or recrystallized, and most of the crystal grains of the Ru film 30 may be predominantly aligned in the <001> orientation, which is a vertical direction. The ratio of the area of the crystal grains aligned in the <001> orientation to the area of the crystal grains of the Ru film 30 may be, for example, about 70% to 100%, and within the range, may be about 75% to 100%, about 80% to 100%, about 85% to 100%, about 90% to 100%, about 95% to 100%, about 97% to 100%, about 98% to 100%, or about 99% to 100%.

By post-annealing, the Ru film 30 may have a decreased misorientation angle of grain boundaries between adjacent crystal grains in the horizontal direction or may exhibit a coincident site lattice (CSL). For example, the misorientation angle of grain boundaries between adjacent crystal grains may be about 15 degrees or less with respect to the horizontal direction of the Ru film 30, or the Ru film 30 may have the CSL such as Σ7, Σ13, Σ19, and/or Σ31.

By post-annealing, the crystal grain size in the Ru film 30 may be larger than the crystal grain size of the Ru deposited product 30a, and the average crystal grain size in the Ru film 30 may be about 50 nm or more, and within the range, may be about 60 nm or more, about 70 nm or more, about 80 nm or more, about 90 nm or more, or about 100 nm or more, and within the range, may be about 50 nm to about 200 nm, about 60 nm to about 200 nm, about 70 nm to about 200 nm, about 80 nm to about 200 nm, about 90 nm to about 200 nm, or about 100 nm to about 200 nm.

Referring to FIG. 1, an upper surface of the Ru film 30 is flattened to form the Ru film 30 with a fine line width, embedded in the trench 21. The upper surface of the Ru film 30 may be polished by, for example, chemical mechanical polishing (CMP), but is not limited thereto.

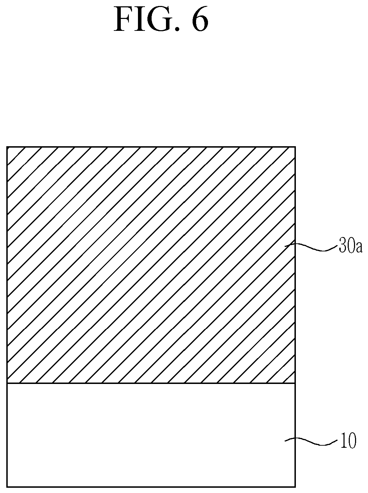

Another example of a method of manufacturing an interconnect structure according to an embodiment is described. FIGS. 6 to 9 are schematic views that indicate the steps of a method of manufacturing an interconnect structure according to an embodiment.

An example of a method of manufacturing an interconnect structure according to one embodiment includes forming the Ru deposited product 30a on the film 10, post-annealing the Ru deposited product 30a to form the Ru film 30, and patterning the Ru film 30. Referring to FIG. 6, the Ru deposited product 30a is formed on the film 10. The Ru deposited product 30a may be formed, for example, by a deposition such as atomic layer deposition (ALD) or chemical vapor deposition (CVD).

The ALD or CVD may be performed at a temperature of about 550° C or less under a process pressure (a deposition pressure or a chamber pressure) of 10 Torr or less, and within the range of about 500° C or less, or about 450° C or less, and within the range, may be performed at a temperature of about 220° C to about 550° C, about 220° C to about 500° C, about 220° C to about 450° C, about 250° C to about 550° C, about 250° C to about 500° C, about 250° C to about 450° C, about 300° C to about 550° C, about 300° C to about 500° C, about 300° C to about 450° C, about 350° C to about 550 ° C, about 350° C to about 500° C, or about 350° C to about 450° C.

The ALD or CVD may form the Ru deposited product 30a with a desired thickness by introducing or supplying a Ru precursor, performing a first purging, supplying at least one of an oxidizing agent or a reducing agent as co-reactants and an inert gas, and performing a secondary purging. Collectively, the steps correspond to one process cycle. The process cycle may be repeated in one or more cycles. That is, the process cycle may be repeated once or more times. As described above, the carbon content in the Ru deposited product 30a may be controlled by adjusting the substrate temperature, the deposition pressure, and/or the partial pressure of the co-reactant (e.g., oxygen partial pressure) during the deposition. For example, the carbon content may be lowered as the substrate temperature increases, the deposition pressure decreases, and/or the partial pressure of the co-reactant (e.g., oxygen partial pressure) decreases. The specific description is as described above.

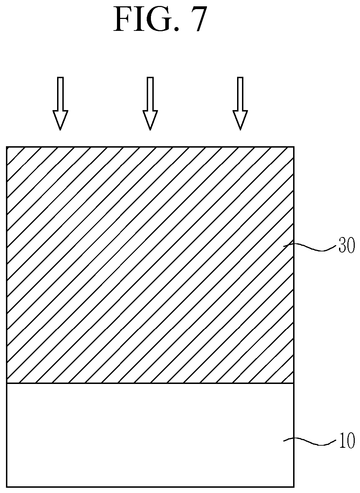

Referring to FIG. 7, the Ru deposited product 30a is post-annealed to form the Ru film 30. The post-annealing may be performed at a temperature of about 550°C or less, and within that range, may be performed at a temperature of about 500°C or less or about 450°C or less, and within that range, may be performed at a temperature of about 220°C to about 550°C, about 220°C to about 500°C, about 220°C to about 450°C, about 250°C to about 550°C, about 250°C to about 500°C, about 250°C to about 450°C, about 300°C to about 550°C, about 300°C to about 500°C, about 300°C to about 450°C, about 350°C to about 550°C, about 350°C to about 500°C, or about 350°C to about 450°C. As described above, following the post-annealing the carbon content in the Ru film 30 may be less than the carbon content in the Ru deposited product 30a, the Ru film 30 may have a crystal orientation reinforced in the vertical and horizontal directions compared to the Ru deposited product 30a, and/or the crystal grain size of the Ru film 30 may be larger than the crystal grain size of the Ru deposited product 30a. The detailed description is as described above.

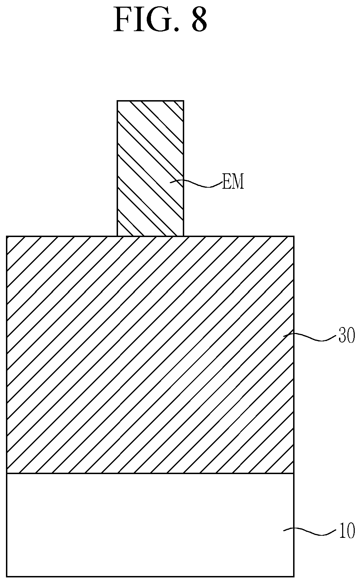

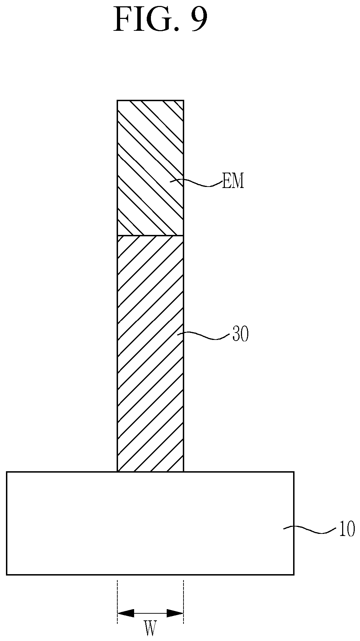

Referring to FIG. 8, an etching mask EM is placed on the Ru film 30. Referring to FIG. 9, the Ru film 30 is etched and patterned using the etching mask EM to form the patterned Ru film 30. The etching may be, for example, dry etching using plasma, but is not limited thereto. Subsequently, the etching mask EM is removed.

The line width of the patterned Ru film 30 may be less than about 20 nm, for example, about 18 nm or less, about 15 nm or less, about 12 nm or less, about 10 nm or less, about 9 nm or less, about 8 nm or less, about 7 nm or less, about 6 nm or less, about 5 nm or less, about 4 nm or less, or about 3 nm or less, and within the range, may be greater than or equal to about 1 nm and less than about 20 nm, about 1 nm to about 18 nm, about 1 nm to about 15 nm, about 1 nm to about 12 nm, about 1 nm to about 10 nm, about 1 nm to about 9 nm, about 1 nm to about 8 nm, about 1 nm to about 7 nm, about 1 nm to about 6 nm, about 1 nm to about 5 nm, about 1 nm to about 4 nm, or about 1 nm to about 3 nm.

Referring to FIG. 1, a dielectric film 20 may be positioned on a surface and an opposite surface of the ruthenium film, e.g., the patterned Ru film 30, for example, by a gap fill method that fills a space between the adjacent patterned Ru films 30, but is not limited thereto.

An example of an integrated circuit device including the interconnect structure is described. The integrated circuit device may be a DRAM or a three-dimensional logic device, but is not limited thereto.

An integrated circuit device according to one embodiment includes a semiconductor substrate, a circuit device integrated in or positioned on the semiconductor substrate, and a via or wiring electrically connected to the circuit device.

The semiconductor substrate may include, for example, a group IV semiconductor material, a group III-V semiconductor compound, or a group II-VI semiconductor compound. For example, the group IV semiconductor material may include at least one of Si, Ge, Sn, or C, the group III-V semiconductor compound may include at least one of B, Ga, In, or Al and at least one of N, P, As, or Sb, and the group II-VI semiconductor compound may include at least one of Be, Mg, Cd, or Zn and at least one of O, S, Se, or Te. For example, the semiconductor substrate may include Si, Ge, SiC, SiGe, SiGeC, a Ge alloy, GaAs, InAs, InP, and the like, but is not limited thereto.

The circuit device may include, for example, a transistor, a capacitor, a diode, a resistor, or a combination thereof, and the Ru film 30 of the interconnect structure 100 may be applied to wires (e.g., bit lines, word lines, etc.) and/or vias of a back end of line (BEOL) structures that are electrically connected to the circuit devices such as transistors.

For example, the transistor may have various structures, for example FinFET, GAAFET, MBCFET, CFET or VFET, but is not limited thereto. For example, the transistor may be a complementary field effect transistor (C-FET), a multi bridge channel field effect transistor (MBC-FET) or a carbon nanotube field effect transistor (CNT-FET), but not limited thereto.

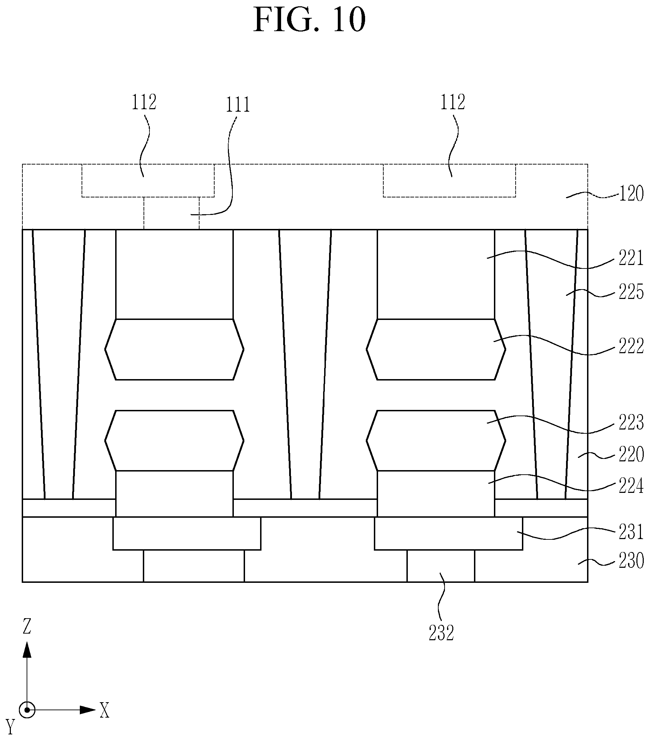

FIG. 10 is a cross-sectional view showing a three-dimensional logic device as an example of an integrated circuit device according to one embodiment. In FIG. 10, the upper dielectric film 120, the upper via 111, and the upper wiring 112 indicated by a dotted line may be a BEOL structure, and the BEOL structure exemplarily describes a structure electrically connected to a circuit device (e.g., a transistor) of a three-dimensional logic device indicated by a solid line.

The upper via 111 and/or the upper wiring 112 in the BEOL structure may be or include the Ru film 30 described above, and the upper dielectric film 120 may be the dielectric film 20 described above surrounding the upper wiring 112 on three surfaces of the upper wiring 112 and/or the perimeter surface of a cylindrical upper via 111. The Ru film 30 and the dielectric film 20 are described above. The upper via 111 and/or the upper wiring 112 in the BEOL structure may be electrically connected to an upper contact layer 221 (active region) formed in an intermediate dielectric film 220, and the upper contact layer 221 may be the film 10 described above. Another wiring (not shown) may be positioned on the upper wiring 112 and electrically connected to the upper wiring 112.

The upper source or drain electrode 222 is positioned under the upper contact layer 221 in an intermediate dielectric film 220, and the lower source or drain electrode 223 is positioned facing the upper source or drain electrode 222 with the intermediate dielectric film 220 interposed therebetween. A lower contact layer 224 (active region) is positioned under the lower source or drain electrode 223, and the lower contact layer 224 is electrically connected to the lower via 231 and/or the lower wiring 232 formed in the lower dielectric film 230. The through contact 225 is formed in the intermediate dielectric film 220.

The three-dimensional logic device, which is an example of an integrated circuit element, is described, but is not limited thereto, and may be applied to all integrated circuit devices including a via and/or a wiring with a fine line width. For example, the integrated circuit device may be used for arithmetic operations, program execution, and/or temporary data retention.

The aforementioned interconnect structure and/or integrated circuit devices may be included in various electronic devices. The electronic device may include mobile devices, computers, laptops, tablet PCs, smart watches, sensors, digital cameras, e-books, network devices, vehicle navigation systems, Internet of Things (IoT) devices, Internet of Everything (IoE) devices, drones, door locks, safes, automated teller machines (ATMs), security devices, medical devices, or automotive electrical components, but are not limited thereto.

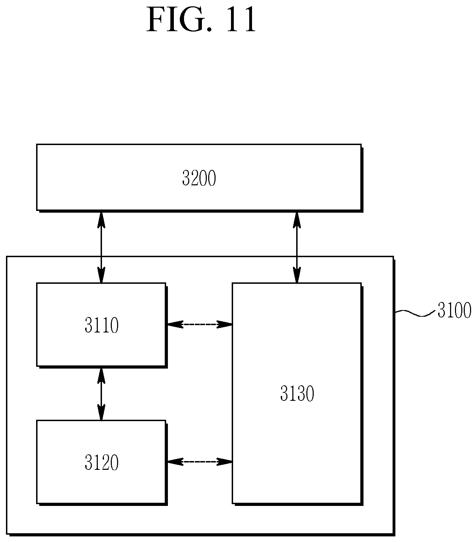

FIG. 11 is a conceptual view showing an example of an electronic device according to an embodiment. Referring to FIG. 11, an electronic device 3100 according to an embodiment may include a memory unit 3110, an arithmetic logic unit 3120, and a control unit 3130, which may be electrically connected. For example, the memory unit 3110, the arithmetic logic unit 3120, and the control unit 3130 may be implemented as a single integrated circuit device (semiconductor chip), and may be monolithically integrated on a single substrate to be implemented as a single integrated circuit device (semiconductor chip). The memory unit 3110, the arithmetic logic unit 3120, and the control unit 3130 may each independently include a transistor, a capacitor, a diode, a resistor, or a combination thereof. The electronic device 3100 may be connected to one or more input/output devices 3200.

Hereinafter, the embodiments are illustrated in more detail with reference to examples. However, these examples are exemplary, and the present scope is not limited thereto.

### Forming of Ruthenium Film

### Example 1

A silicon wafer with an amorphous silicon oxide layer of a thickness of 100 nm formed thereon is placed as a substrate (substrate temperature: 270°C) in a chamber (1 Torr or less) of a showerhead-type atomic layer deposition device, and tricarbonyl(trimethylenemethane)ruthenium (Ru(TMM)(CO)₃) and bis(ethylcyclopentadienyl)ruthenium(II) (RuEtCP₂) are introduced into the chamber as ruthenium precursors. Argon (Ar) gas is then introduced into the chamber to perform a first purge of the chamber. A mixture of Ar gas and O₂ gas are then introduced at a volume ratio of 9:1 (partial pressure ratio of O₂ gas to Ar gas: 0.1). Thereafter, Ar gas is introduced to perform a secondary purge. Collectively, these steps of deposition/purge describe above correspond to one process cycle to form Ru deposited product monolayer with a thickness of about 1 to 2 angstroms (Å). The process cycle is repeated multiple times to form a Ru deposited product with a thickness of about 10 nm.

The silicon wafer on which the Ru deposited product is formed is removed from the chamber, and placed into rapid thermal process (RTP) equipment and post-annealed at 450°C for 20 minutes under vacuum to form a Ru film.

### Example 2

A Ru film is formed in the same manner as in Example 1, except that the substrate temperature is increased to 300 °C, instead of 270 °C.

### Example 3

A Ru film is formed in the same manner as in Example 1, except that the substrate temperature is increased to 325 °C, instead of 270 °C.

### Example 4

A Ru film is formed in the same manner as in Example 1, except that the substrate temperature is increased to 365 °C, instead of 270 °C.

### Reference Example 1

A Ru film is formed in the same manner as in Example 1, except that the substrate temperature is lowered to 210 °C, instead of 270 °C.

### Reference Example 2

A silicon wafer with an amorphous silicon oxide layer of a thickness of 100 nm formed thereon (substrate temperature: 300°C) is placed in a sputtering chamber (at a pressure of 1 Torr or less) facing a pure Ru target. Sputtering is performed for about 60 seconds to form Ru deposited product with a thickness of about 10 nm. The silicon wafer on which the Ru deposited product is formed is removed from the sputtering chamber, placed into RTP equipment, and post-annealed at 450°C for 20 minutes under vacuum to form a Ru film.

### Evaluation I

The carbon contents in the Ru deposited product (before the post-annealing) and the Ru film (after the post-annealing) according to Examples and Reference Examples are evaluated. The carbon contents in the Ru deposited products and the Ru films are analyzed using a quad secondary ion mass spectroscopy (quad SIMS) using a Ru standard sample as a reference. The results are shown in Table 1.

**Table 1**

| | Carbon Content (at%) | |
|---|---|---|
| | Ru Deposited Product (Before Post-Annealing) | Ru Film (After Post-Annealing) |
| Example 1 | 1.13 | 0.15 |
| Example 2 | 0.48 | 0.16 |
| Example 3 | 0.38 | 0.19 |
| Example 4 | 0.24 | 0.15 |
| Reference Example 1 | 2.03 | 0.34 |

### Evaluation II

The carbon distributions in the Ru deposited products (before the post-annealing) and the Ru films (after the post-annealing) according to Examples are evaluated. The carbon distributions in the Ru films are evaluated from an atom probe tomography (APT) analysis.

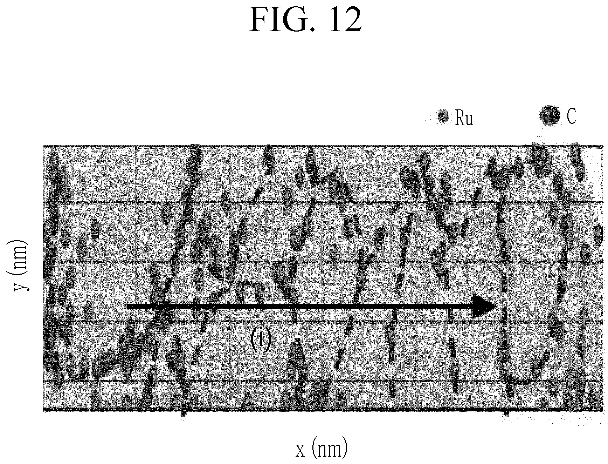

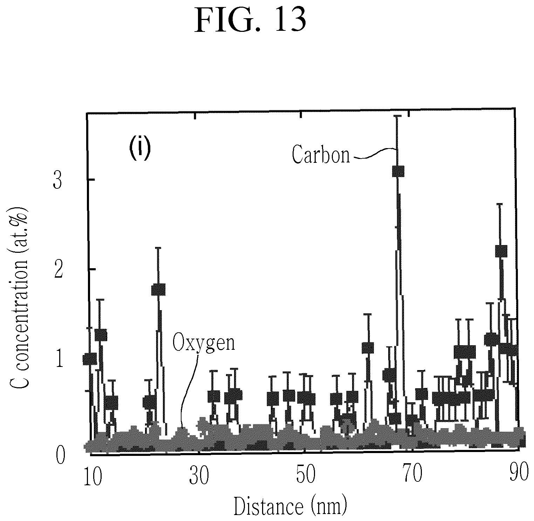

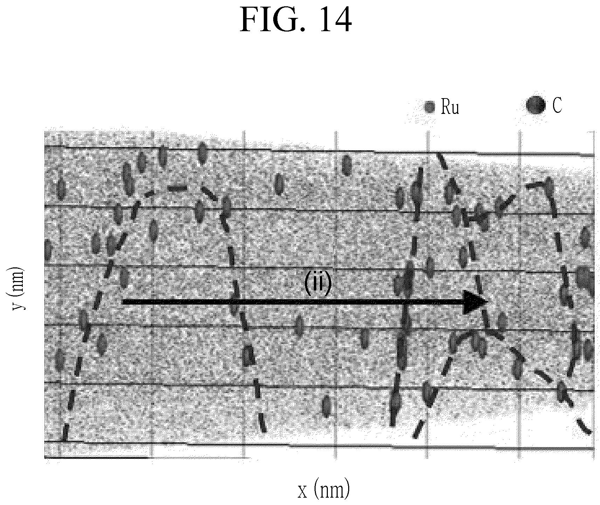

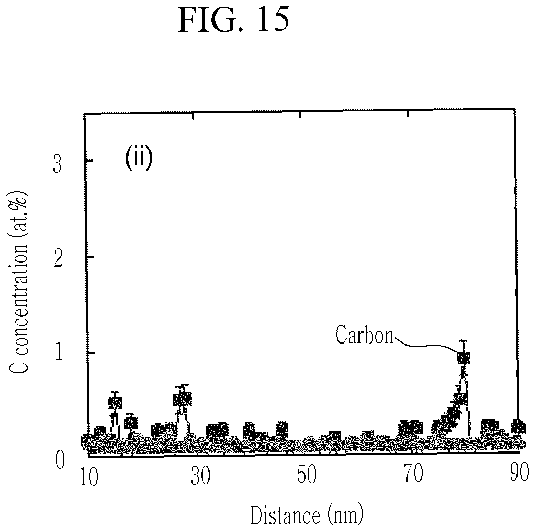

FIG. 12 is an APT analysis showing the carbon distribution in the Ru deposited product according to Example 2; FIG. 13 is a graph showing the carbon concentration according to a position in the Ru deposited product in the APT analysis of FIG. 12; FIG. 14 is an APT analysis showing the carbon distribution in the Ru film according to Example 2; and FIG. 15 is a graph showing the carbon concentration according to a position in the Ru film in the APT analysis of FIG. 14.

In FIGS. 12 and 14, dotted lines represent grain boundaries. Referring to FIGS. 12 to 15, it may be confirmed that carbon may be mainly distributed or aggregated along the grain boundaries in the Ru deposited product and the Ru film, and it may be confirmed that a significant amount of carbon in the Ru deposited product may be released during the post-annealing. Accordingly, the carbon content may be decreased after post-annealing. In addition, it may be confirmed that the grain boundaries may migrate during crystal grain growth with the release of carbon distributed along the grain boundaries during the post-annealing, and thereby, expanding the crystal grains and increasing the crystal grain size.

### Evaluation III

The crystallographic orientations of the Ru deposited products (before the post-annealing) and the Ru films (after the post-annealing) according to Examples and Reference Examples are evaluated.

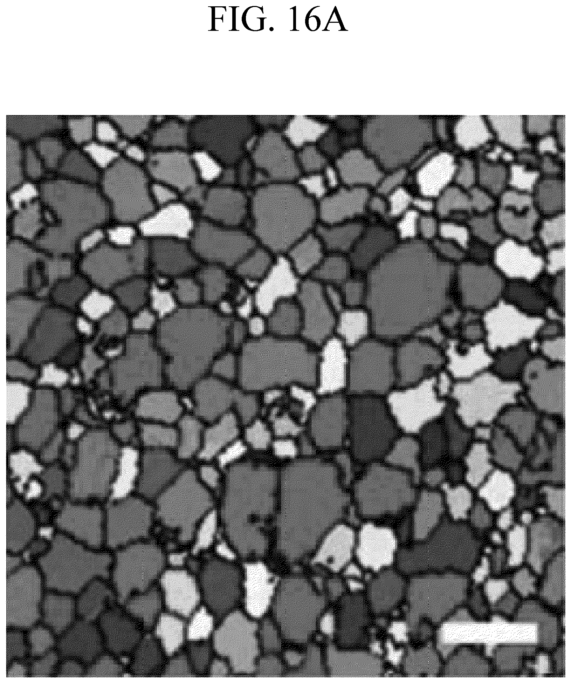

The crystallographic orientations are evaluated from transmission electron microscopy (TEM) and/or precession electron diffraction (PED) orientation maps using PED orientation microscopy. The results are shown in FIGS. 16A to 20B and Table 2.

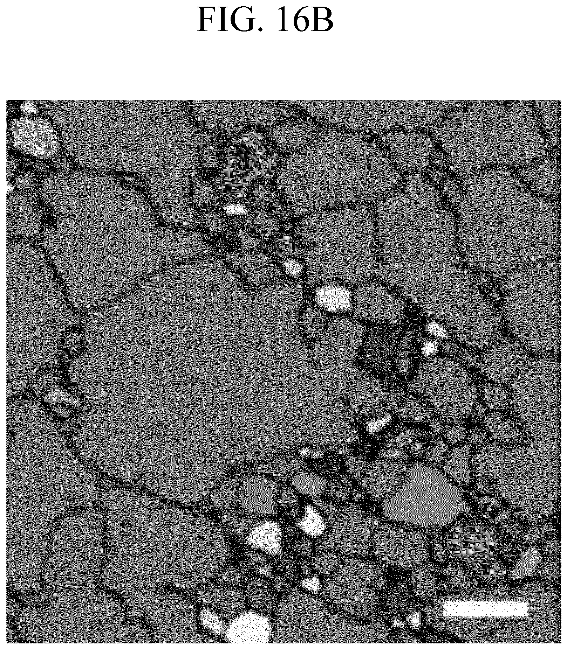

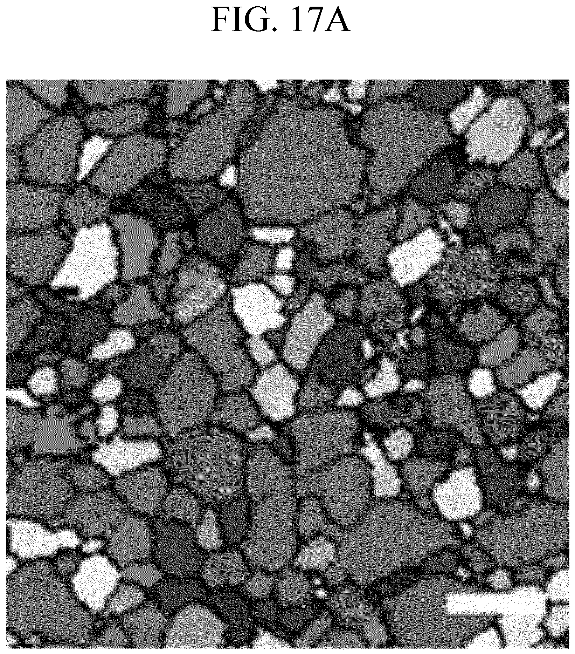

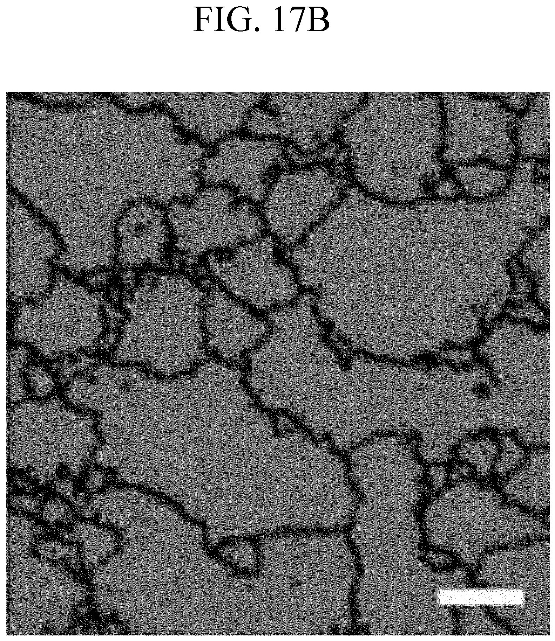

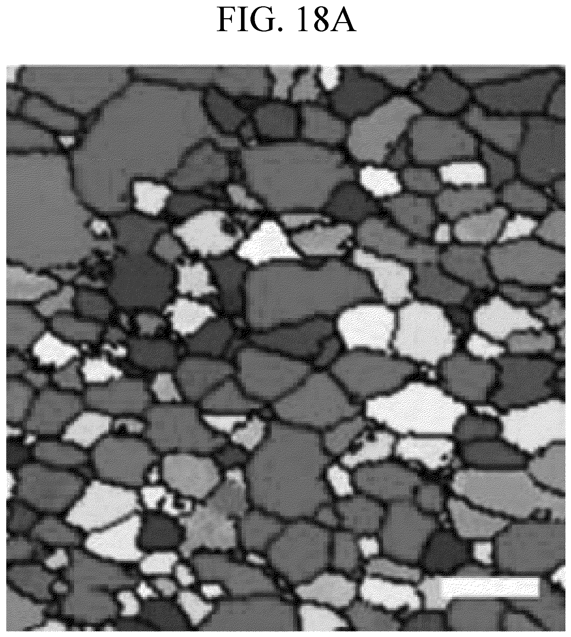

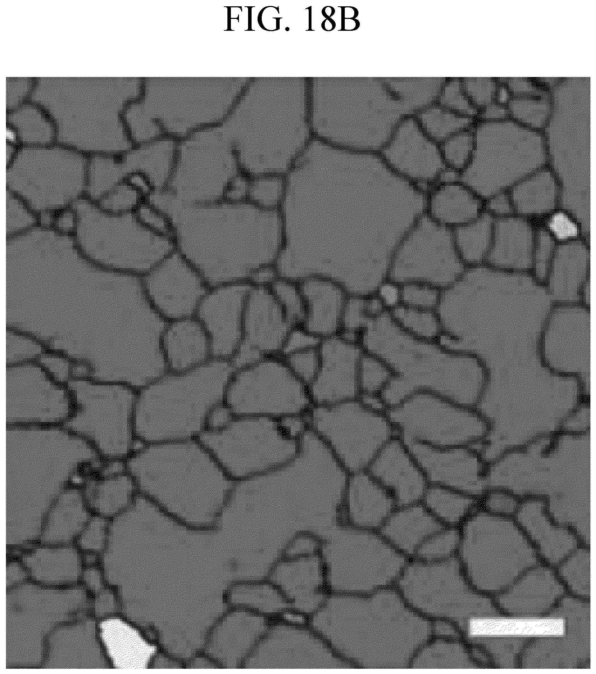

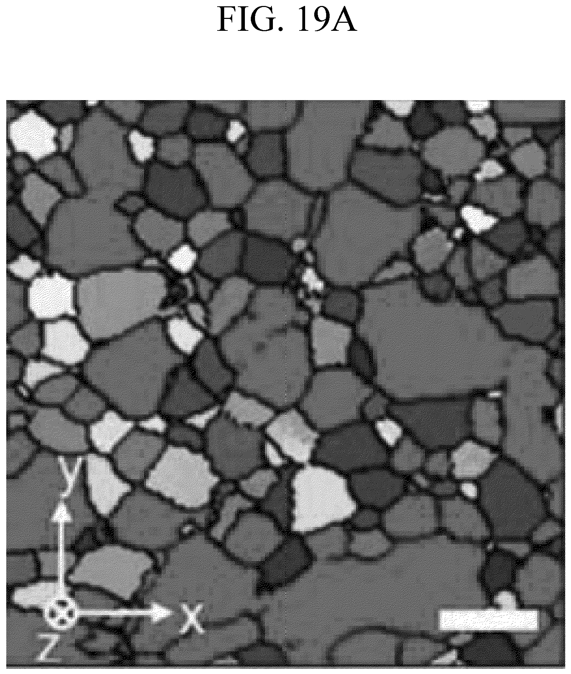

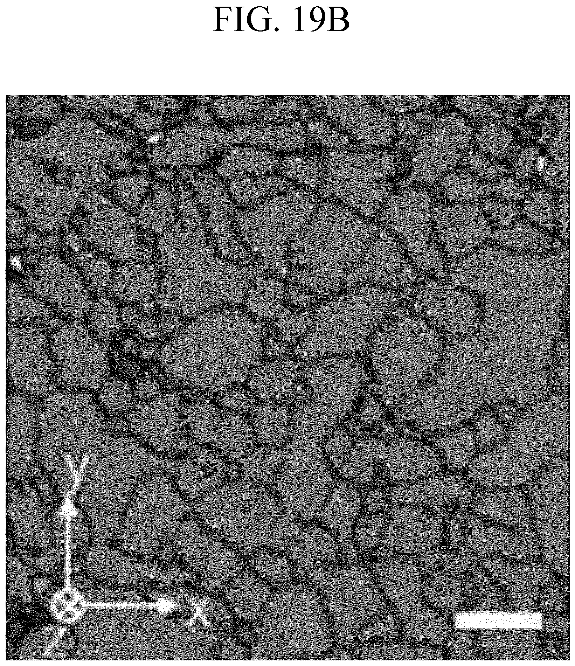

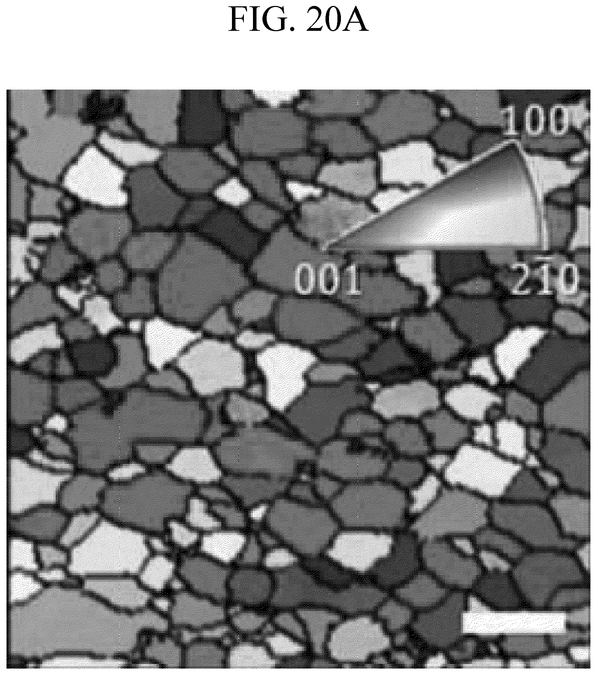

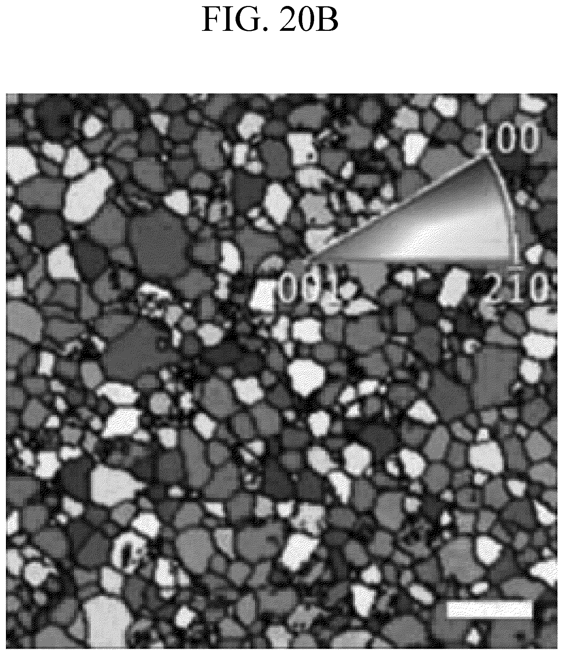

FIGS. 16A and 16B are PED orientation maps along the z-axis direction (the direction perpendicular to the substrate surface) of the Ru deposited product and the Ru film according to Example 1, respectively. FIGS. 17A and 17B are PED orientation maps along the z-axis direction of the Ru deposited product and the Ru film according to Example 2, respectively. FIGS. 18A and 18B are PED orientation maps along the z-axis direction of the Ru deposited product and the Ru film according to Example 3, respectively. FIGS. 19A and 19B are PED orientation maps along the z-axis direction of the Ru deposited product and the Ru film according to Example 4, respectively. FIGS. 20A and 20B are PED orientation maps along the z-axis direction of the Ru deposited product and the Ru film according to Reference Example 1, respectively. In FIGS. 16A to 20B, the size of each PED orientation map is about 500 nm x 500nm.

In FIGS. 16A to 20B, colors correspond to crystallographic orientations, for example, <001> orientation is shown in red, <100> orientation in blue, and <210> orientation in green. The scale bar of the PED orientation maps of the Ru deposited products is 30 nm, and the scale bar of the PED orientation maps of the Ru films is 100 nm.

**Table 2**

| | Crystal Grain Texturing Factor (*F*₀₀₁) x 100 (%) | |
|---|---|---|
| | Ru Deposited Product (Before Post-Annealing) | Ru Film (After Post-Annealing) |
| Example 1 | 22.8 | 86.3 |
| Example 2 | 41.1 | 99.8 |
| Example 3 | 42.9 | 97.8 |
| Example 4 | 55.4 | 96.6 |
| Reference Example 1 | 14.5 | 31.8 |

Referring to Table 2 and FIGS. 16A to 19B, it may be confirmed that most of the crystal grains in the Ru films according to Examples are strongly oriented in the direction perpendicular to the substrate surface (c-axis direction, <001> orientation) by post-annealing, such that the *F*₀₀₁ percentage is about 70% or more (e.g., about 80% or more or about 85% or more), and that there may be a large change in the crystallographic orientation before and after post-annealing. In contrast, referring to Table 2 and FIGS. 20A and 20B, it may be confirmed that crystal grains in the Ru film according to Reference Example 1 may have various crystallographic orientations, that is, randomly oriented, even after the post-annealing, and that there may be no large change in the crystallographic orientation before and after the post-annealing.

From this, it may be confirmed that the crystallographic orientation of the Ru film may be affected by the initial carbon content and the final carbon content, and for example, it may be confirmed that the <001> orientation may be dominant when the initial carbon content is about 1.50 at% or less and the final carbon content is less than about 0.30 at%.

### Evaluation IV

The average crystal grain sizes of the Ru deposited products (before the post-annealing) and the Ru films (after the post-annealing) according to Examples and Reference Examples are confirmed. The average crystal grain size is evaluated using the ASTAR^{™} orientation mapping methodology. The results are shown in Table 3.

**Table 3**

| | Average Crystal Grain Size (nm) | | change in crystal grain size by post-annealing |
|---|---|---|---|
| | Ru Deposited Product Before Post-Annealing | Ru Film After Post-Annealing | |
| Example 1 | 11 | 62.8 | 5.7 x |
| Example 2 | 13.3 | 114.3 | 8.6 x |
| Example 3 | 13.4 | 67.3 | 5.0 x |
| Example 4 | 14.4 | 56.4 | 3.9 x |
| Reference Example 1 | 12.2 | 30.27 | 2.5 x |

Referring to Table 3, it may be confirmed that the Ru films according to Examples may have an average crystal grain size increase by about 4 times or more by post-annealing. Moreover, it may be confirmed that the Ru film according to Example 2 has a relatively large average crystal grain size of about 100 nm or more, and has the largest change in the average crystal grain size before and after the post-annealing, i.e., 8.6 x, of the Example films. In contrast, it may be confirmed that the Ru film according to Reference Example 1 has a change in crystal grain size of about 2.5 x before and after the post-annealing.

From this, it may be confirmed that the crystal grain size of the Ru film is affected by the initial carbon content and the final carbon content, and it may also be confirmed that relatively large crystal grains of size of about 50 nm or more are formed when the initial carbon content is about 1.50 at% or less and the final carbon content is less than about 0.30 at%.

### Evaluation V

X-ray diffraction patterns (XRD) of the Ru deposited products (before the post-annealing) and the Ru films (after the post-annealing) according to Examples and Reference Examples are evaluated.

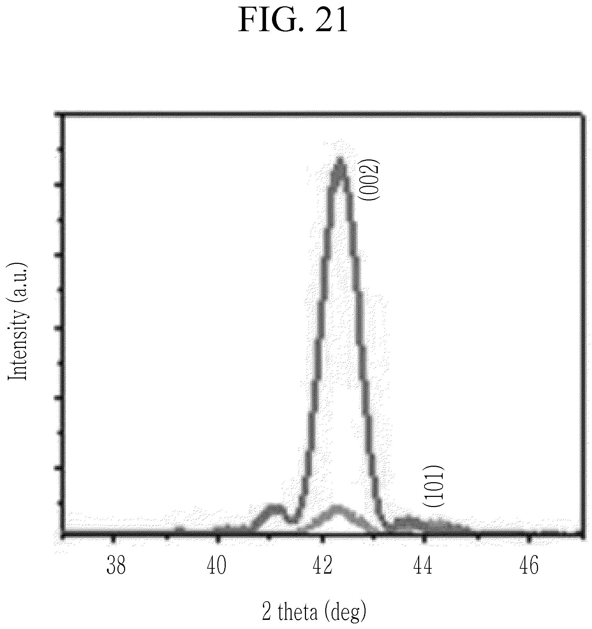

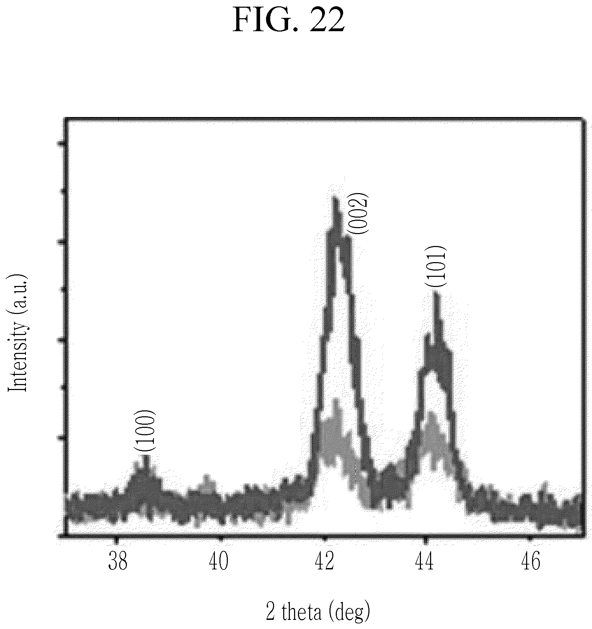

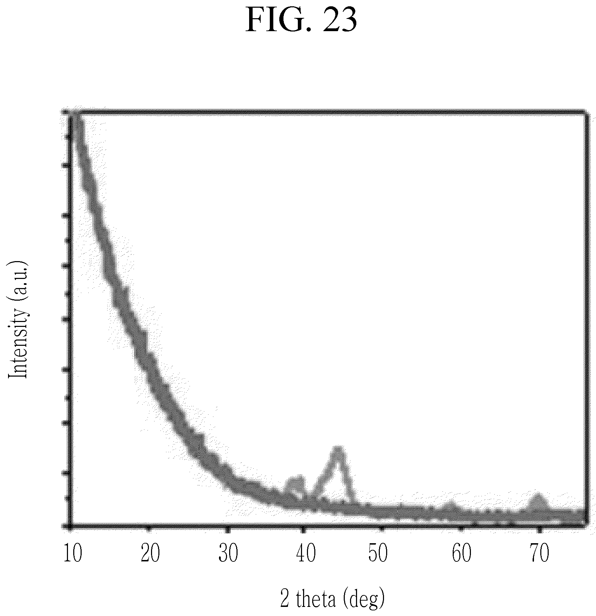

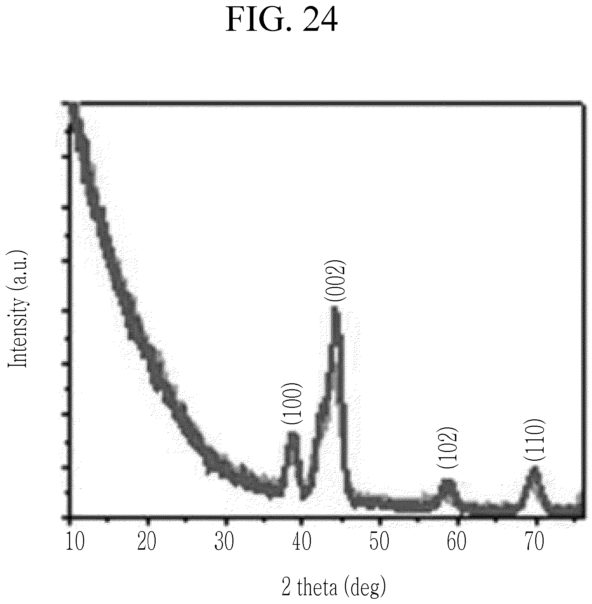

FIG. 21 is an XRD pattern measured at a normal angle of the Ru deposited product and the Ru film according to Example 2. FIG. 22 is an XRD pattern measured at a normal angle of the Ru deposited product and the Ru film according to Reference Example 1. FIG. 23 is an XRD pattern at a low-angle (0.5 degree relative to the substrate surface) glancing angle incidence of the Ru deposited product and the Ru film according to Example 2. FIG. 24 is an XRD pattern at a low-angle (0.5 degree relative to the substrate surface) glancing angle incidence of the Ru deposited product and the Ru film according to Reference Example 1.

In FIGS. 21 to 24, the gray line is the XRD patterns of the Ru deposited products, and the red or green line is the XRD patterns of the Ru films. Referring to FIGS. 21 and 22, in the Ru film according to Example 2, the (002) peak (2θ=42.3 degrees) corresponding to the <001> orientation is predominantly observed, and the (100) peak (2θ=38.5 degrees) and the (101) peak (2θ=44.2 degrees) are substantially absent, i.e., not observed. In contrast, in the Ru film according to Reference Example 1, in addition to the (002) peak, the (100) and (101) peaks are also observed in relatively significant amounts. In addition, it may be confirmed that the Ru film according to Example 2 (red line) has a significant increase in the (002) peak in relation to the Ru deposited product (gray line).

Further, referring to FIGS. 23 and 24, it may be confirmed that the Ru film according to Example 2 has no peak observed in the range of about 30 to about 70 degrees. In contrast, the Ru film according to Reference Example 1 has a significant amount of (100), (110), and (102) peaks, in addition to the (002) peak. In addition, it may be confirmed that lots of peaks disappear in the Ru film according to Example 2 (red line) compared to the Ru deposited product (gray line). Accordingly, it may be confirmed that, unlike the random orientation of the Ru film according to Reference Example 1, the Ru film according to Example 2 has most of the crystal grains (about 99% or more) predominantly aligned in the <001> orientation. In addition, it may be confirmed that the orientation of the Ru film according to Example 2 may be further reinforced by post-annealing.

### Evaluation VI

The grain boundaries of the Ru films according to Examples and Reference Examples are evaluated. The grain boundaries of the Ru films are evaluated by transmission electron microscopy (TEM).

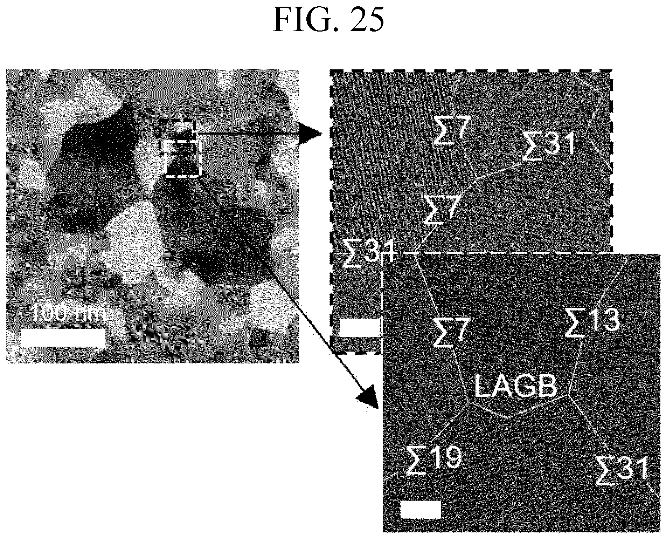

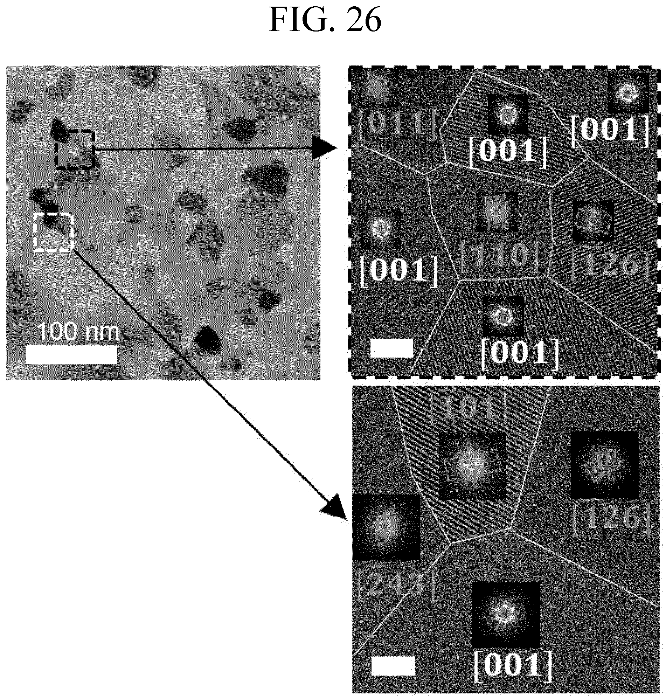

FIG. 25 is a TEM image showing the grain boundaries of the Ru film according to Example 2, and FIG. 26 is a TEM image showing the grain boundaries of the Ru film according to Reference Example 2. Referring to FIG. 25, it may be confirmed that in the Ru film according to Example 2, coincident site lattice (CSL) grain boundaries such as Σ7, Σ19, and Σ31 and low angle CSL grain boundaries primarily appear. In contrast, referring to FIG. 26, in the Ru film according to Reference Example 2, it may be confirmed that a considerable number of non-CSL grain boundaries are present along with CSL grain boundaries including Σ13 grain boundaries. Because the specific resistivity that occurs when current passes through non-CSL grain boundaries is greater than that of CSL grain boundaries, it may be expected that the resistance of the Ru film made of CSL grain boundaries or a wiring/via including the Ru film is lower. Accordingly, it may be expected that the Ru film according to Example 2 may promote the formation of low-angle CSL grain boundaries with lower grain boundary energy by the release of carbon from the grain boundaries during post-annealing, and thus, may have lower resistance.

### Evaluation VII

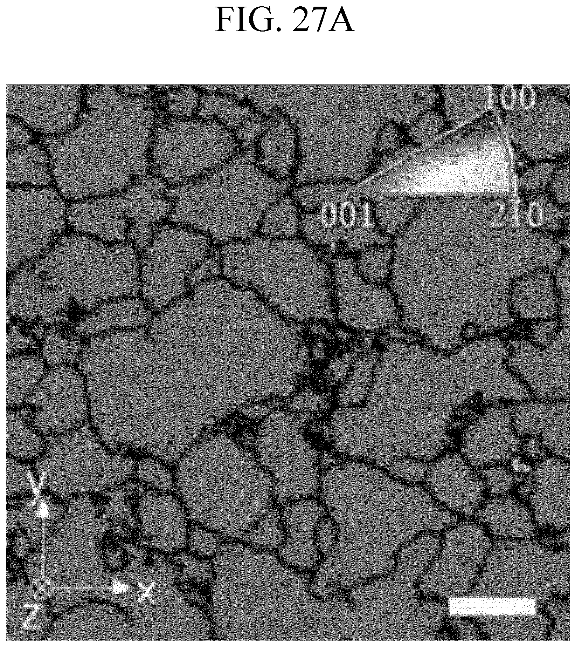

The crystallographic orientation in the vertical and horizontal directions of the Ru films according to Examples and Reference Examples are confirmed. The results are as shown in FIGS. 27A to 29B.

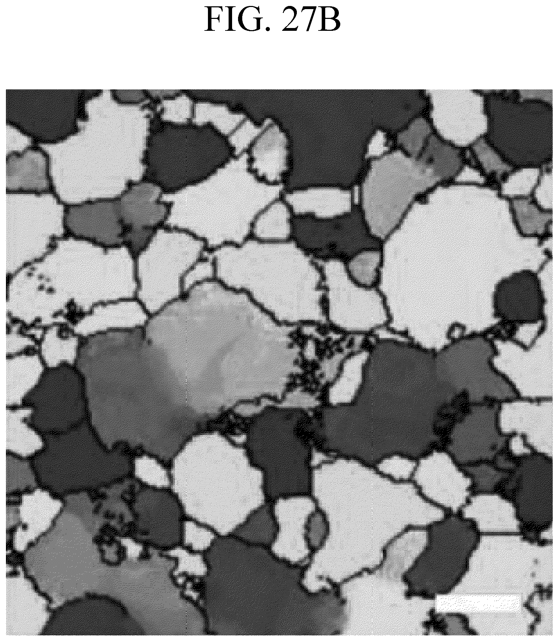

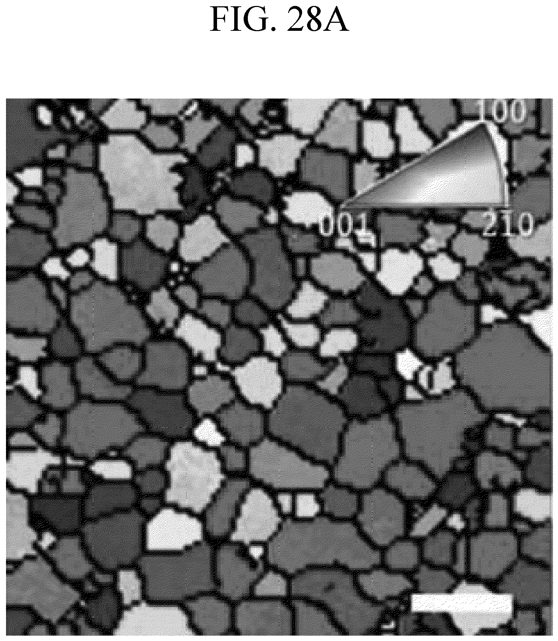

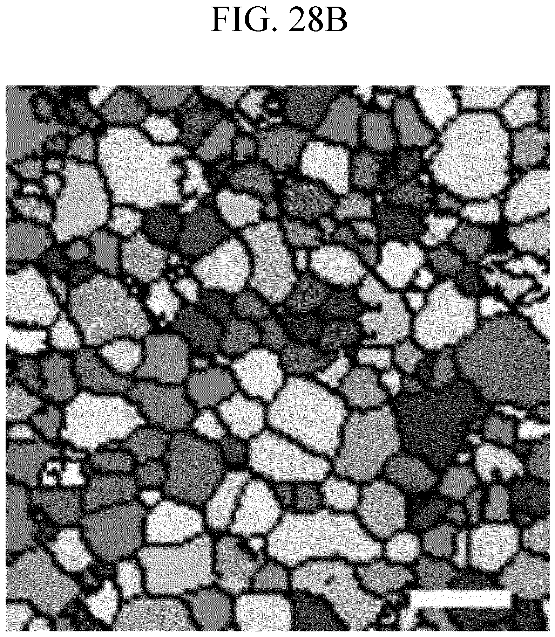

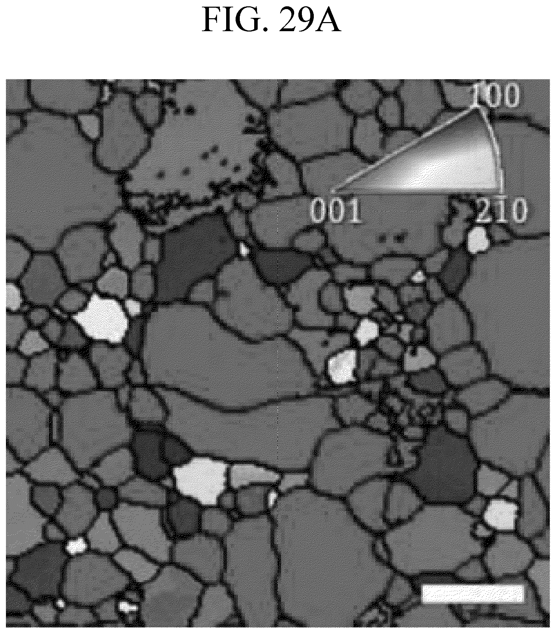

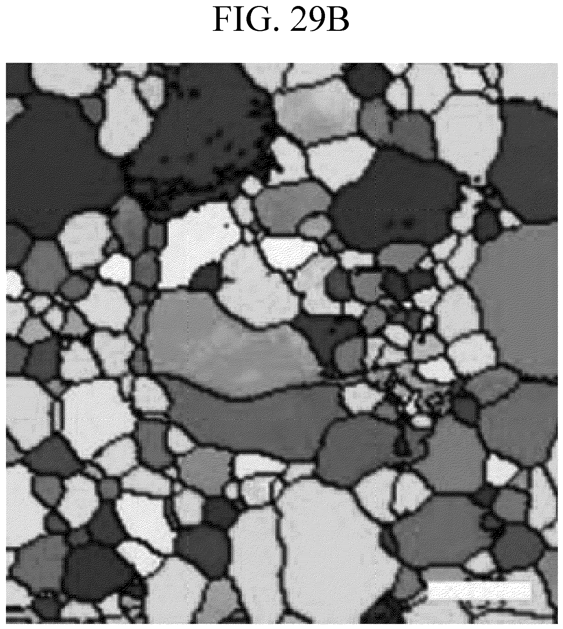

FIGS. 27A and 27B are PED orientation maps along the z-axis direction (the direction perpendicular to the substrate surface) and the x-axis direction (the direction parallel to the substrate surface) of the Ru film according to Example 2, respectively. FIGS. 28A and 28B are PED orientation maps along the z-axis and x-axis directions of the Ru film according to Reference Example 1, respectively FIGS. 29A and 29B are PED orientation maps along the z-axis and x-axis directions of the Ru film according to Reference Example 2, respectively.

In FIGS 27A to 29B, the colors correspond to the crystallographic orientations, for example, <001> orientation is shown in red, <100> orientation is shown in blue, and <210> orientation is shown in green. The scale bar of the PED orientation maps of the Ru films is 100 nm. Referring to FIGS. 27A and 27B, it may be confirmed that most of crystal grains of the Ru film according to Example 2 are strongly oriented in a direction perpendicular to the substrate surface (namely, c-axis direction, <001> orientation) (FIG. 27A) and also there may be small misorientation between adjacent crystal grains arranged along a direction parallel to the substrate surface (FIG. 27B).

In contrast, referring to FIGS. 28A and 28B, it may be confirmed that the Ru film according to Reference Example 1 has crystal grains with various crystallographic orientations, i.e., randomly oriented. In addition, referring to FIGS. 29A and 29B, it may be confirmed that the Ru film according to Reference Example 2 has a large misorientation between adjacent crystal grains arranged in a direction parallel to the substrate surface, and a large amount of very small crystal grains interspersed among abnormally grown large crystal grains, resulting in a large deviation in the crystal grain size.

### Evaluation VIII

The surface roughness of the Ru deposited products and the Ru films according to Examples and Reference Examples are evaluated. Surface roughness is measured in tapping mode of an atomic force microscopy (AFM, Dimension Icon XR, Bruker Corporation) instrument. The results are shown in Table 4.

**Table 4**

| | Surface Roughness (nm) | |
|---|---|---|
| | Ru Deposited Product (Before Post-Annealing) | Ru Film (After Post-Annealing) |
| Example 2 | 0.33 | 0.41 |
| Reference Example 1 | 1.51 | 1.61 |
| Reference Example 2 | 0.25 | 0.68 |

Referring to Table 4, it may be confirmed that the Ru film according to Example has a smoother surface in comparison to the Ru films according to the Reference Examples. Accordingly, it may be expected that the Ru film according to the Examples may effectively reduce electron surface scattering compared to the Ru films according to the Reference Examples.

### Evaluation IX

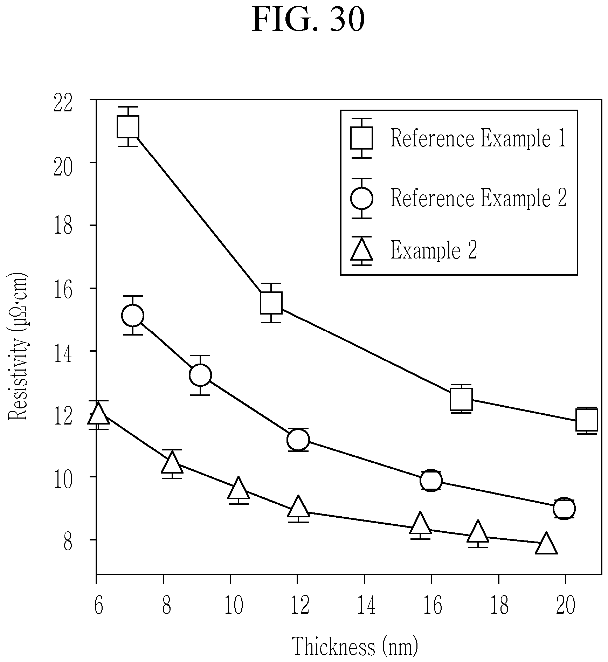

The Ru films according to Examples and Reference Examples are formed in various thicknesses (line widths) of 6 nm to 20 nm, and the electrical characteristics according to the thickness (line width) of the Ru films are evaluated. The electrical characteristics of the Ru films are evaluated by obtaining the sheet resistance using the four-point probe method and then obtaining the resistivity using the sheet resistance and the thickness of the film measured using the TEM method. The result is as shown in FIG. 30.

FIG. 30 is a graph showing the change in resistivity according to the thickness (line width) of the Ru films according to Example 2 and Reference Examples 1 and 2.

Referring to FIG. 30, it may be confirmed that the Ru film according to Example 2 has a smaller change in resistivity with decreasing line width in comparison to the Ru films according to Reference Examples 1 and 2. In particular, it may be confirmed that the resistivity of the Ru film according to Example 2 is significantly lower than that of the Ru films according to Reference Examples 1 and 2 at line widths of 10 nm or less.

Accordingly, it may be expected that the Ru film according to Example 2 may prevent deterioration of electrical characteristics without a rapid increase in resistance even at a fine line width of less than about 20 nm (for example, about 15 nm or less or about 10 nm or less).

While the embodiments of the present disclosure have been described in detail, it is to be understood that the disclosure is not limited to the disclosed embodiments, but on the contrary, is intended to cover various modifications and equivalent arrangements included within the scope of the appended claims.
(1) An interconnect structure including a film including non-single crystalline material, and a ruthenium film positioned on the film and including crystal grains is provided. A crystal grain texturing factor, F₀₀₁, of the crystal grains with <001> orientation of the ruthenium film may be about 0.7 to about 1, and an average crystal grain size of the ruthenium film may be about 50 nm to about 200 nm.
(2) The non-single crystalline material may include an amorphous conductor, a polycrystalline conductor, an amorphous semiconductor, a polycrystalline semiconductor, an amorphous dielectric, a polycrystalline dielectric, or a combination thereof.
(3) The interconnect structure may further include a dielectric film on a surface and an opposite surface of the ruthenium film or surrounding the ruthenium film on at least two sides of the ruthenium film.
(4) In an X-ray diffraction pattern of the ruthenium film, the ratio of the intensity of the (002) peak to the intensity of the (101) peak may be about 30 to about 100.
(5) In an X-ray diffraction pattern of the ruthenium film, the intensity of the (002) peak may be about 90% to 100% of the sum of the intensities of the (100), (101), and (002) peaks.
(6) A misorientation angle of grain boundaries between adjacent crystal grains of the ruthenium film may be 0 to about 15 degrees with respect to the horizontal direction of the ruthenium film.
(7) The grain boundaries (e.g., Most, if not all, of them) between adjacent crystal grains of the ruthenium film may have a coincidence site lattice.
(8) An average surface roughness of the ruthenium film may be greater than 0 and less than about 1.0 nm.
(9) The ruthenium film may include carbon in an amount of greater than or equal to about 0.01 at% and less than about 0.30 at%.
(10) The carbon may be distributed along grain boundaries between adjacent crystal grains of the ruthenium film.
(11) A ratio of an area of the crystal grains with <001> orientation to the area of the crystal grains of the ruthenium film may be about 95 % to about 100 %. Alternatively, this corresponds to a crystal grain texturing factor, *F*₀₀₁, of about 0.7 to 1.
(12) An average crystal grain size of the ruthenium film may be about 80 nm to about 200 nm.
(13) An average crystal grain size of the ruthenium film may be about 55 nm to about 115 nm.
(14) A line width of the ruthenium film may be greater than or equal to about 1 nm and less than about 20 nm.
(15) A method for manufacturing an interconnect structure including providing a ruthenium precursor on a film including a non-single crystalline material to form a ruthenium deposited product, and post-annealing the ruthenium deposited product to form a ruthenium film is provided. A ratio of an area of the crystal grains with <001> orientation to the area of crystal grains of the ruthenium film may be about 70 to about 100% (this corresponds to that the crystal grains with <001> orientation of the ruthenium film may have a crystal grain texturing factor, *F*₀₀₁, of about 0.7 to 1), and an average crystal grain size of the ruthenium film may be about 50 nm to about 200 nm.
(16) The forming of the ruthenium deposited product and the post-annealing of the ruthenium deposited product may be performed independently at a temperature of about 220°C to about 550°C.
(17) The ruthenium film may include carbon in an amount of greater than or equal to about 0.01 at% and less than about 0.30 at%.
(18) The ruthenium deposited product may include carbon more than that in the ruthenium film.
(19) The ruthenium deposited product may include carbon in an amount of about 0.10 at% to about 1.50 at%.
(20) A ratio of an area of crystal grains with the <001> orientation to the area of crystal grains of the ruthenium deposited product may be less than about 60% (this corresponds to that a crystal grain texturing factor, *F*₀₀₁, of crystal grains with the <001> orientation of the ruthenium deposited product may be less than 0.6).
(21) The average crystal grain size of the ruthenium deposited product may be greater than or equal to about 1 nm and less than about 20 nm.
(22) At least one of an oxidizing agent or a reducing agent and an inert gas may be supplied or introduced with the ruthenium precursor or supplied after the introduction of the ruthenium precursor.
(23) The oxidizing agent may include oxygen, ozone, water, or plasma active species derived therefrom, and the reducing agent may include hydrogen gas, ammonia gas or plasma active species derived therefrom.
(24) The partial pressure ratio of at least one of the oxidizing agent or the reducing agent to the inert gas may be about 0.05 to about 1.
(25) The providing of the ruthenium precursor may be performed in one or more process cycles as described herein, for example, 1 to 50 process cycles.
(26) An integrated circuit device includes a semiconductor substrate, a circuit device integrated in the semiconductor substrate or positioned on the semiconductor substrate, and a wiring electrically connected to the circuit device and including a ruthenium film. A ratio of an area of crystal grains with <001> orientation of the ruthenium film to the area of crystal grains of the ruthenium film may be about 70 to about 100% (this corresponds to that the crystal grains with <001> orientation of the ruthenium film may have a crystal grain texturing factor, *F*₀₀₁, of about 0.7 to 1), and an average crystal grain size of the ruthenium film may be about 50 nm to about 200 nm.
(27) The integrated circuit device may further include a film positioned under the wiring and including non-single crystalline material, wherein the non-single crystalline material may include an amorphous conductor, a polycrystalline conductor, an amorphous semiconductor, a polycrystalline semiconductor, an amorphous dielectric, a polycrystalline dielectric, or a combination thereof.
(28) The integrated circuit device may further include a dielectric film on a surface and an opposite surface of the wiring or surrounding the wiring, e.g., on at least two sides of the wiring.
(29) The ruthenium film may include carbon in an amount of greater than or equal to about 0.01 at% and less than about 0.30 at%.
(30) A misorientation angle of grain boundaries between adjacent crystal grains of the ruthenium film may be about 0 to about 15 degrees with respect to the horizontal direction of the ruthenium film, or grain boundaries (e.g., most, if not all, of them) between adjacent crystal grains of the ruthenium film may have a coincidence site lattice.
(31) An average surface roughness of the ruthenium film may be greater than about 0 and less than about 1.0 nm.
(32) A line width of the ruthenium film may be greater than or equal to about 1 nm and less than about 20 nm.
(33) An integrated circuit device includes a semiconductor substrate, a circuit device integrated in the semiconductor substrate or positioned on the semiconductor substrate, a dielectric film positioned on the circuit device and having a trench, and a ruthenium film positioned in the trench and including crystal grains. The crystal grains with <001> orientation may be the most among the crystal grains of the ruthenium film, and a misorientation angle of grain boundaries between the adjacent crystal grains of the ruthenium film may be about 0 to about 15 degrees with respect to the horizontal direction of the ruthenium film, or each grain boundary between the adjacent crystal grains of the ruthenium film may have a coincidence site lattice.
(34) A crystal grain texturing factor of the crystal grains with <001> orientation of the ruthenium film may be about 0.95 to 1.
(35) An average crystal grain size of the ruthenium film may be about 80 nm to about 200 nm.
(36) An average surface roughness of the ruthenium film may be greater than about 0 and less than about 1.0 nm.
(37) The line width of the ruthenium film may be less than about 20 nm.
(38) An aspect ratio, the ratio of depth to line width, of the ruthenium film may be about 3 to about 50.
(39) The resistivity of the ruthenium film may be about 15 µΩ • cm or less.
(40) The ruthenium film may be positioned on a film exposed through a via hole, and the film may include an amorphous conductor, a polycrystalline conductor, an amorphous semiconductor, a polycrystalline semiconductor, an amorphous dielectric, a polycrystalline dielectric, or a combination thereof.

## Claims

1. An interconnect structure comprising:
a film including a non-single crystalline material: and
a ruthenium film positioned on the film and including crystal grains,
wherein crystal grains with <001> orientation of the ruthenium film has a crystal grain texturing factor, *F*₀₀₁, of about 0.7 to 1, and
an average crystal grain size of the ruthenium film is about 50 nanometers to about 200 nanometers.

2. The interconnect structure of claim 1, wherein the non-single crystalline material comprises an amorphous conductor, a polycrystalline conductor, an amorphous semiconductor, a polycrystalline semiconductor, an amorphous dielectric, a polycrystalline dielectric, or a combination thereof.

3. The interconnect structure of claim 1 or 2, further comprising a dielectric film on a surface and an opposite surface of the ruthenium film.

4. The interconnect structure of one of claims 1 to 3, wherein:
in an X-ray diffraction pattern of the ruthenium film, a ratio of the intensity of a (002) peak to an intensity of a (101) peak is about 30:1 to about 100:1; or
in an X-ray diffraction pattern of the ruthenium film, the intensity of a (002) peak is about 90% to 100% of the sum of the intensities of the (100), (101), and (002) peaks.

5. The interconnect structure of one of claims 1 to 3, wherein a misorientation angle of grain boundaries between adjacent crystal grains of the ruthenium film is 0 to about 15 degrees with respect to the horizontal direction of the ruthenium film as determined by transmission electron microscopy analysis.

6. The interconnect structure of one of claims 1 to 3, wherein a grain boundary between adjacent crystal grains of the ruthenium film has a coincidence site lattice.

7. The interconnect structure of one of claims 1 to 3, wherein
an average surface roughness of the ruthenium film is greater than 0 and less than about 1.0 nanometer, or
the ruthenium film with a line width of less than 20 nm will have a change in resistivity of less than about 2 times due to a 10% decrease in line width.

8. The interconnect structure of one of claims 1 to 3, wherein the ruthenium film comprises carbon in an amount of greater than or equal to about 0.01 at% and less than about 0.30 at%, and the carbon is distributed along grain boundaries between adjacent crystal grains of the ruthenium film.

9. The interconnect structure of one of claims 1 to 3, wherein the crystal grain texturing factor, *F*₀₀₁, of the crystal grains with <001> orientation is about 0.85 to 1, and
wherein:
the crystal grain texturing factor, *F*₀₀₁, of the crystal grains with <001> orientation is about 0.95 to 1, and/or an average crystal grain size of the ruthenium film is about 80 nanometers to about 200 nanometers; or
a line width of the ruthenium film is greater than or equal to about 1 nanometer and less than about 20 nanometers.

10. An integrated circuit device comprising
a semiconductor substrate,
a circuit device integrated in the semiconductor substrate or positioned on the semiconductor substrate,
a wiring electrically connected to the circuit device, and
an interconnect structure according to claim 1, wherein the ruthenium film including crystal grains is included in the wiring, and wherein the film including the non-single crystalline material is positioned under the wiring.

11. The integrated circuit device of claim 10, wherein the non-single crystalline material comprises an amorphous conductor, a polycrystalline conductor, an amorphous semiconductor, a polycrystalline semiconductor, an amorphous dielectric, a polycrystalline dielectric, or a combination thereof.

12. The integrated circuit device of claim 10 or 11, wherein the crystal grains with <001> orientation has a crystal grain texturing factor, *F*₀₀₁, of about 0.85 to 1, and/or the ruthenium film comprises carbon in an amount of greater than or equal to about 0.01 at% and less than about 0.30 at%; or
a misorientation angle of grain boundaries between adjacent crystal grains of the ruthenium film is 0 to about 15 degrees with respect to the horizontal direction of the ruthenium film, or
a grain boundary between the adjacent crystal grains of the ruthenium film has a coincidence site lattice.

13. The integrated circuit device of claim 10 or 11, wherein:
an average surface roughness of the ruthenium film is greater than 0 and less than about 1.0 nanometers; and/or
a line width of the ruthenium film is greater than or equal to about 1 nanometer and less than about 20 nanometers.

14. A method for providing an integrated circuit device, the method comprising:
providing a semiconductor substrate, wherein a circuit device integrated in the semiconductor substrate or positioned on the semiconductor substrate,
positioning a dielectric film on the circuit device, the dielectric film having a trench, and
positioning a ruthenium film in the trench, the ruthenium film including crystal grains,
wherein the crystal grains with <001> orientation account for greater than 90 percent of the crystal grains, and
a misorientation angle of grain boundaries between adjacent crystal grains of the ruthenium film is 0 to about 15 degrees with respect to the horizontal direction of the ruthenium film, or
a grain boundary between adjacent crystal grains of the ruthenium film has a coincidence site lattice.

15. The integrated circuit device of claim 14, wherein
the crystal grains with <001> orientation account for about 95% to 100% of the crystal grains,
an average crystal grain size of the ruthenium film is about 80 nanometers to about 200 nanometers, and/or
an average surface roughness of the ruthenium film is greater than 0 nanometers and less than about 1.0 nanometer.
